# EUROPEAN PATENT SPECIFICATION

(11) **EP 1 384 205 B1**
(45) Date of publication and mention of the grant of the patent: **24.01.2007**
(21) Application number: 00982359.2
(22) Date of filing: 01.12.2000
(51) Int. Cl.: G06T 7/00

(54) **WAFER MAPPING APPARATUS AND METHOD**
Verfahren und Vorrichtung zur Zuordnung von Wafern
APPAREIL ET PROCEDE DE REPRESENTATION DE PLAQUETTES

(43) Date of publication of application: 28.01.2004
(73) Proprietor: Wafermasters, Incorporated, San Jose, CA 95112 (US)
(72) Inventor: YOO, Woo, Sik, Palo Alto, CA 94303 (US); KANG, Kitaek, Dublin, CA 94568 (US)
(74) Representative: Freeman, Jacqueline Carol
(86) International application number: PCT/US2000/032769
(87) International publication number: WO 2003/100725

(56) References cited:
- US-A- 5 771 308
- PATENT ABSTRACTS OF JAPAN vol. 014, no. 082 (E-0889), 15 February 1990 (1990-02-15) & JP 01 295436 A (NEC CORP), 29 November 1989 (1989-11-29)
- PATENT ABSTRACTS OF JAPAN vol. 014, no. 374 (E-0964), 13 August 1990 (1990-08-13) & JP 02 135752 A (YASKAWA ELECTRIC MFG CO LTD), 24 May 1990 (1990-05-24)
- PATENT ABSTRACTS OF JAPAN vol. 014, no. 387 (E-0967), 21 August 1990 (1990-08-21) & JP 02 142157 A (NIPPON M R C KK), 31 May 1990 (1990-05-31)

## Description

### BACKGROUND OF THE INVENTION

### 1. Field of the Invention

The present invention generally relates to semiconductor manufacturing equipment and more particularly to systems and methods for mapping semiconductor wafers.

### 2. Description of the Related Art

A semiconductor manufacturing equipment is used to process semiconductor wafers into electronic devices. Typically, in this equipment, the wafers are contained in a carrier. While in the carrier, the wafers are "mapped" to determine the number of wafers to be processed and the slot location of each wafer in the carrier. Wafer mapping enables the manufacturing equipment to return a processed wafer to the original slot location from which the wafer came. Returning the wafer into its original slot location in the carrier is important because equipment operators rely on slot locations to distinguish the wafers. Knowing the number of wafers contained in the carrier is also important because the manufacturing equipment needs to know when all the wafers in the carrier have been processed to alert an equipment operator or to move the carrier out of a load lock.

Wafer mapping has been performed using laser beams. Typically, the carrier is slowly moved in a vertical direction to cross the path of a horizontally aimed laser beam. A computer keeps track of when and how many times the wafers break the beam. By knowing the distance between the slots of the carrier, the computer can determine the number of wafers and the location of each wafer in the carrier. Because each wafer in the carrier is moved to break the beam, using a laser beam to perform wafer mapping takes time. Further, detecting a cross-slotted wafer (i.e. a single wafer which occupies two slots) is difficult using a laser beam because of the limited area which a beam can cover.

For technological background, reference may be made to United States Patent Number 5,771,308. Reference may also be made to Patent Abstracts of Japan vol. 014, no. 082 (E-0889), 15 February 1990 and JP 01 295436 A (NEC Corporation), 29 November 1989, which generally discloses an image recognizing sensor, which detects the presence or absence of wafers in slots.

### SUMMARY OF THE INVENTION

According to the present invention there is provided a method for detecting a wafer position in a carrier having a plurality of slots from an acquired image of the wafer by detecting a first feature of the wafer at a first location in a first column of the image, the method characterized by: detecting a second feature of the wafer at a second location in a second column of the image; and comparing the first location in the first column to the second location in the second column to determine the orientation of the wafer.

The present invention can thus provide a method for mapping semiconductor wafers and wafer-like objects contained in a carrier or container. In one embodiment, an image of a carrier containing a wafer is acquired using, for example, a video camera. The image is digitized and stored in a computer as an array (i.e. row and column) of pixels, each pixel representing a point on the image. The intensity values of all pixels in a column of the image is then extracted. Because the presence of a wafer against a contrasting background generates an intensity variation in the pixels of the acquired image, the presence of the wafer can be determined by looking for variations in pixel intensity. A cross-slotted wafer is similarly detected by extracting the intensity of all pixels in two columns of the image. When a wafer is not cross-slotted, the pixel intensity variation corresponding to the wafer occurs on the same row of the image regardless of which column is being analyzed. The row location of a pixel intensity variation for a cross-slotted wafer, however, depends on the column of the image. This is because a cross-slotted wafer, which occupies two slots in the carrier, is at an angle with respect to the plane of a slot and thus intersects the columns of the image at different rows.

The invention only needs to acquire a single image of a carrier to determine the number and location of wafers in the carrier. This allows for a fast wafer mapping system with minimal moving parts. This is in marked contrast with techniques in the prior art where each wafer in the carrier is moved vertically to break a laser beam. The single acquired image can also be used to detect cross-slotted wafers, a task which is complicated and requires multiple sensors when the laser beam technique is used.

A wafer mapping system (100) uses a camera (100) to acquire an image of a carrier (201) containing wafers. The acquired is stored as rows and columns of pixels. The presence and location of a wafer in the carrier (201) are determined by looking for pixel intensity variations in a column of the image.

Other uses, advantages, and variations of the present invention will be apparent to one of ordinary skill in the art open reading this disclosure and accompanying drawings.

### BRIEF DESCRIPTION OF THE DRAWINGS

FIG. 1A shows a pictorial diagram of a wafer mapping system in accordance with the present invention.
FIGS. 1B and 1C are pictorial diagrams showing possible mounting locations for the wafer mapping system shown in FIG. 1A
FIG. 2 shows an image of a wafer carrier mapped in accordance with the present invention.
FIG. 3 shows a plot of total intensity versus row location for pixels in a column of the image shown in FIG. 2.
FIG. 4 shows an image of a wafer carrier containing cross-slotted wafers.
FIG. 5 shows a plot of total intensity versus row location for pixels in a column of the image shown in FIG. 4.
FIG. 6 shows a plot of total intensity versus row location for pixels in another column of the image shown in FIG. 4.
FIG. 7 shows the plot shown in FIG. 5 superimposed on the plot shown in FIG. 6.

### DETAILED DESCRIPTION

The present invention provides a method and associated apparatus for detecting semiconductor wafers and wafer-like objects contained in a carrier or container. The invention may be used in a variety of applications including in the manufacture of semiconductor devices, hard disks, and liquid crystal displays. By way of example, the invention can be used in etching, deposition, chemical-mechanical planarization, and rapid thermal processing systems.

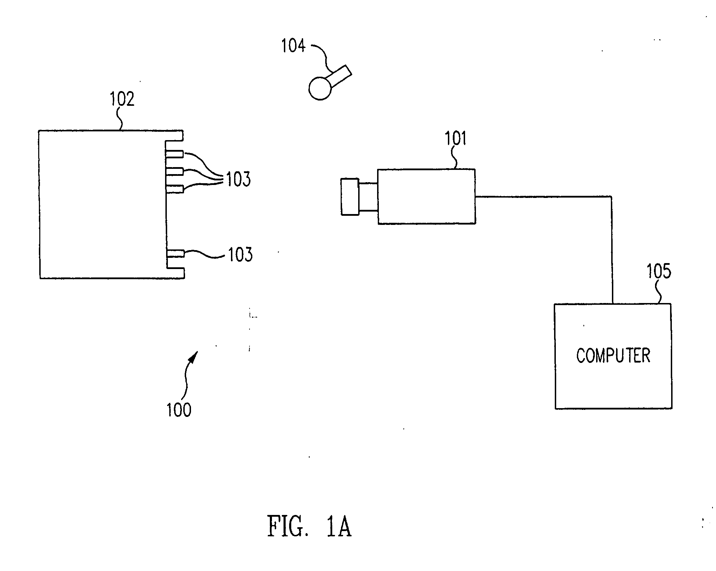

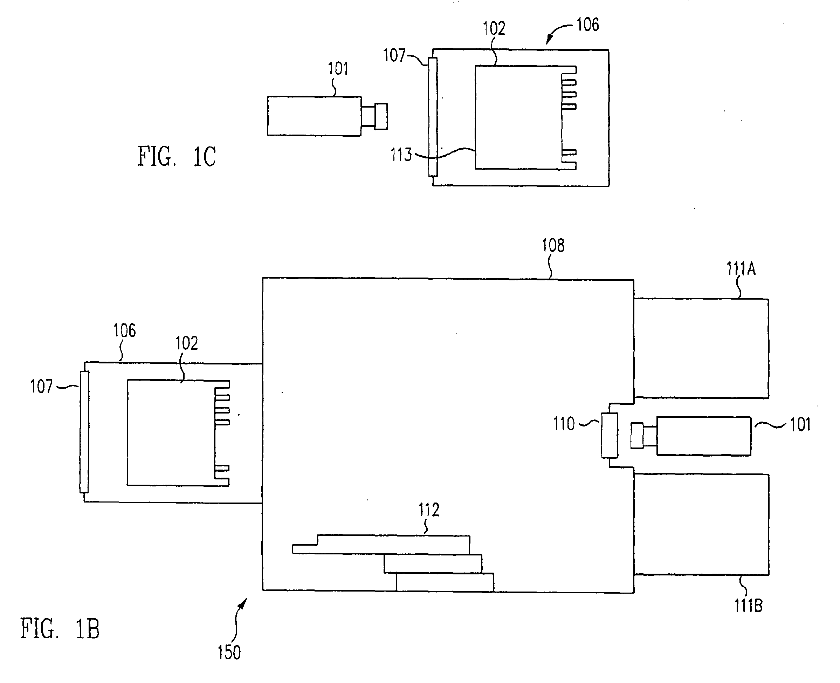

FIG. 1A shows a pictorial diagram of a wafer mapping system 100 in accordance with the present invention. Referring to FIG. 1A, an image of wafers 103 contained in a carrier 102 is acquired using a camera 101. Carrier 102 may be a fixed or removable carrier. In this particular embodiment, camera 101 is a QUICKCAM^{™} Home camera from Logitech Corporation of Fremont, California. Camera 101 may also be any conventional camera such as a video camera, a photographic camera, or a digital camera. Camera 101 is positioned to have a field of view which includes all the wafers in carrier 102. Light source 104 provides lighting when system 100 is employed in a dark environment. The image acquired using camera 101 is provided to a computer 105 for subsequent image processing. If the Logitech QUICKCAM^{™} Home camera is used, the output of camera 101 is a digitized image which is provided to computer 105 via a Universal Serial Bus ("USB") (not shown). Otherwise, the image acquired using camera 101 is first digitized using a conventional digitizer before the image is processed in computer 105.

System 100 can be employed in any location of a semiconductor manufacturing equipment 150 (FIG. 1B) where wafer mapping is desired. As shown in FIG. 1B, camera 101 of system 100 may be mounted between vertically placed reactors 111A and 111B. Camera 101 acquires an image of carrier 102 through a viewing port 110 of a transfer chamber 108. Viewing port 110 is made of a transparent material such as quartz and is directly across a load lock 106 which contains carrier 102. An image of carrier 102 may be acquired using camera 101 while a robot 112 is in a lowered position. Camera 101 may also be mounted to acquire an image of carrier 102 through a viewing port 107 in the back of load lock 106 as illustrated in FIG. 1C. In FIG. 1C, carrier 102 has an open back side 113 which allows viewing of the wafers. While FIGS. 1B and 1C illustrate specific examples of how camera 101 may be positioned in a semiconductor manufacturing equipment, the invention is not so limited. For example, camera 101 does not have to be mounted directly across or at a certain distance from carrier 102. This is because once an image is acquired, conventional image processing techniques can be used (e.g. to digitally "tilt" or to "zoom" to a specific portion of the acquired image) to accommodate various camera mounting configurations and perform wafer mapping in accordance with the invention.

In one embodiment, the digitized image is stored as a bitmap. Bitmaps are known in the art. Generally, a bitmap can be thought of as an array of pixels, each pixel representing a point on the digitized image. By knowing the resolution of the bitmap, the number of pixels in each row and the number of pixels in each column of the bitmap are also known. For example, a 640 x 480 bitmap has 480 rows and 640 columns of pixels. In this disclosure, row 1, column 1 of a bitmap is chosen to be the upper left hand corner of the image. Table A below shows a listing of a C++ programming language source code for extracting the red, green, and blue intensity values of all pixels in a column of a bitmap. Referring to Table A, a bitmap file "wafer0.bmp" (Table A, line 83) of an acquired image is opened for processing. Each pixel in a selected column (Table A, line 96) of bitmap file "wafer0.bmp" is extracted and converted to units of red, green, and blue ("RGB") intensity (Table A, lines 110-115). The resulting intensity values of all pixels in the selected column are written to a temporary data file "test.dat" (Table A, lines 101, 119-120). File "test.dat" can be loaded into a spreadsheet or application program for further processing. The invention can be performed using any pixel or image format. For example, each pixel in the selected column can also be converted to the so-called HSV format (Table A, lines 117, 131-164). Further, pixel unit values (e.g. intensity values) may be scaled and normalized to improve the contrast between a wafer and its background.

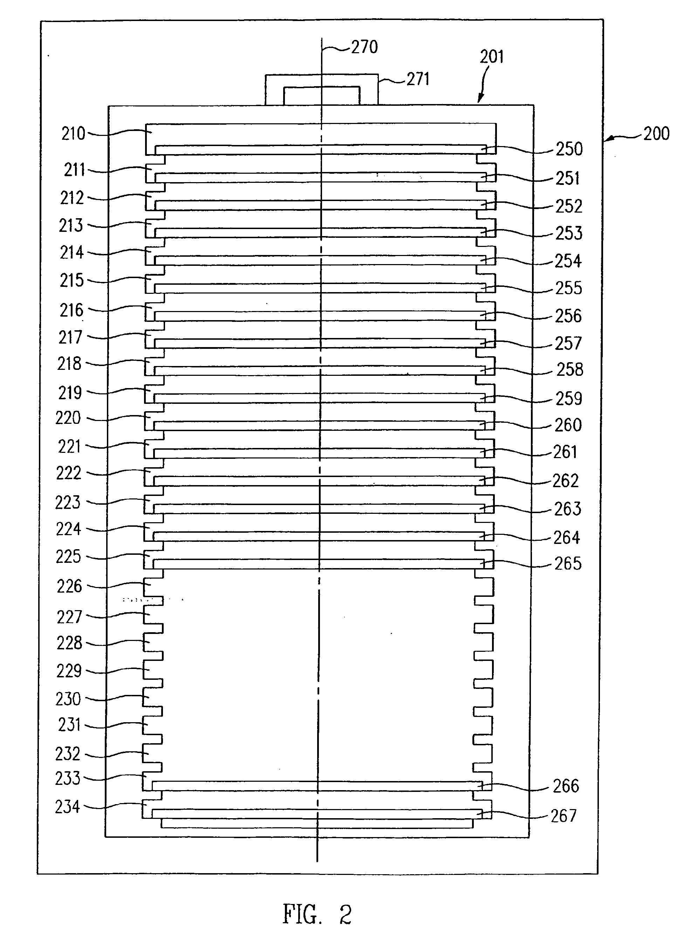

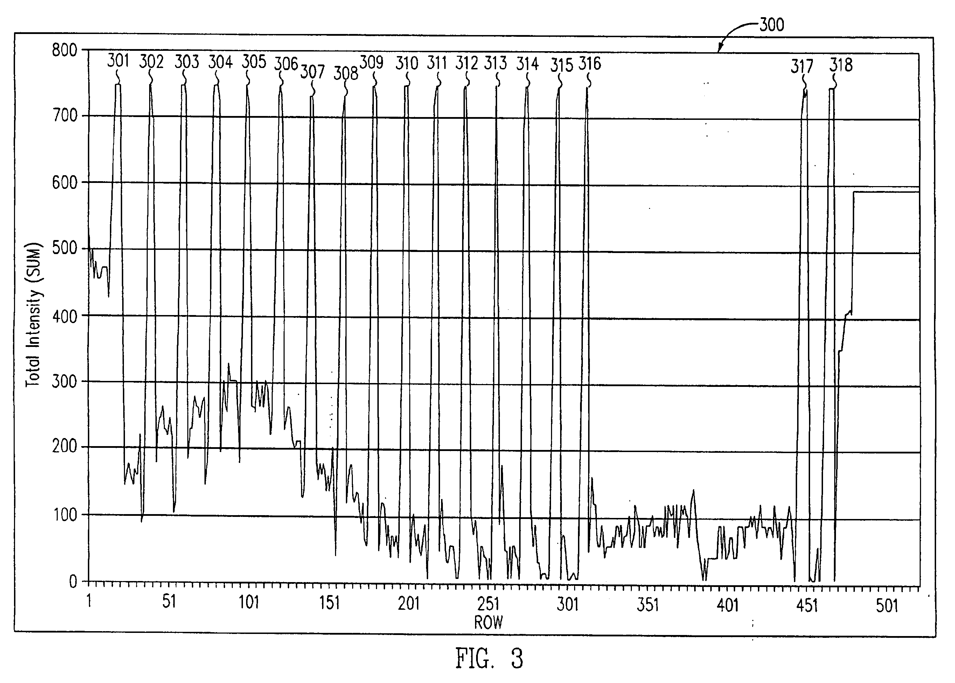

Table B is a table (in spreadsheet format) containing the RGB intensity values of pixels along a line 270 which represents a column of an image 200 (FIG. 2). The intensity values in Table B are imported (i.e. taken) from a data file such as "test.dat" described above. The numbers under the columns "R", "G", and "B" indicate the values of the red, green, and blue intensities for each pixel along line 270 (FIG. 2). The unit for red, green, and blue is an arbitrary unit representing intensity and can be scaled or normalized depending on the specific application. The numbers under the column "SUM" indicate the total of the red, green, and blue intensities for a particular pixel. For example, the first row of numbers in Table B indicates that on the first row of image 200 (row 1), a pixel which lies on line 270 has 173 units of red, 174 units of green, and 173 units of blue for a total intensity (or SUM) of 520 units (i.e. 173 + 174 + 173). FIG. 3 shows a plot 300 of the total intensity versus row location for each pixel along line 270 of image 200.

As shown in FIG. 2, image 200 is an image of a carrier 201. Carrier 201 is a 25-slot wafer carrier having slots 210 to 234. Slot 210 has a wafer 250, slot 211 has a wafer 251, slot 212 has a wafer 252, and so on. Slots 226 to 232 do not have wafers in them. Comparing carrier 201 to plot 300 (FIG. 3), each wafer in carrier 201 has a corresponding pixel peak intensity. Wafer 250 corresponds to a peak 301 in plot 300, wafer 251 corresponds to a peak 302 in plot 300, and so on. This is because a wafer against a contrasting background varies a pixel's intensity. Thus, the presence or absence of a wafer can be determined by looking for peak intensities. A peak intensity can be detected using conventional signal processing techniques such as by setting a threshold. In plot 300 (FIG. 3), for example, any pixel having a total intensity value greater than 600 units (the threshold) indicates the presence of a peak and, thus, the presence of a wafer in the carrier.

A calibration procedure is performed to discriminate "background noise" and to determine the distance between slots (also known as "pitch") for specific applications. Calibration is performed by acquiring and analyzing images of full and partially-filled carriers. For example, the image of a full carrier can be acquired to determine the number of pixel rows between slots. In plot 300 (FIG. 3), peak 301, which corresponds to wafer 250 in slot 210 (FIG. 2), occurs at about row 16. Thus, rows prior to row 16 represent background noise, such as a handle 271 (FIG. 2), and can be ignored by the wafer mapping system. The row corresponding to slot 210, the first slot from the top of carrier 201, is right after the rows corresponding to the background noise. In plot 300, the peaks corresponding to wafers in adjacent slots occur approximately every 18 rows. For example, slot 211 is approximately 18 rows away from slot 210, slot 212 is approximately 36 rows away from slot 210, and so on. Thus, there are approximately 18 rows between slots. Using the above information, wafers 266-267 in slots 233-234 (FIG. 2), which correspond to peaks 317 and 318 in rows 449 and 467 (FIG. 3), can be detected. Missing wafers in slots 226 to 232, which correspond to the absence of peaks between rows 315 and 445, are also similarly determined.

Depending on the specific wafer mapping system and setup employed, a pixel's red, green, or blue intensity value may be used instead of the total intensity. Other formats for representing images, such as the HSV format, and intensity information from "black and white" cameras may also be used. Further, peaks may be detected using any conventional signal processing technique, including by inspection. Although the invention is illustrated by detecting peak intensity, other image signal components which are distinguishable as indicating a feature of a wafer may also be used.

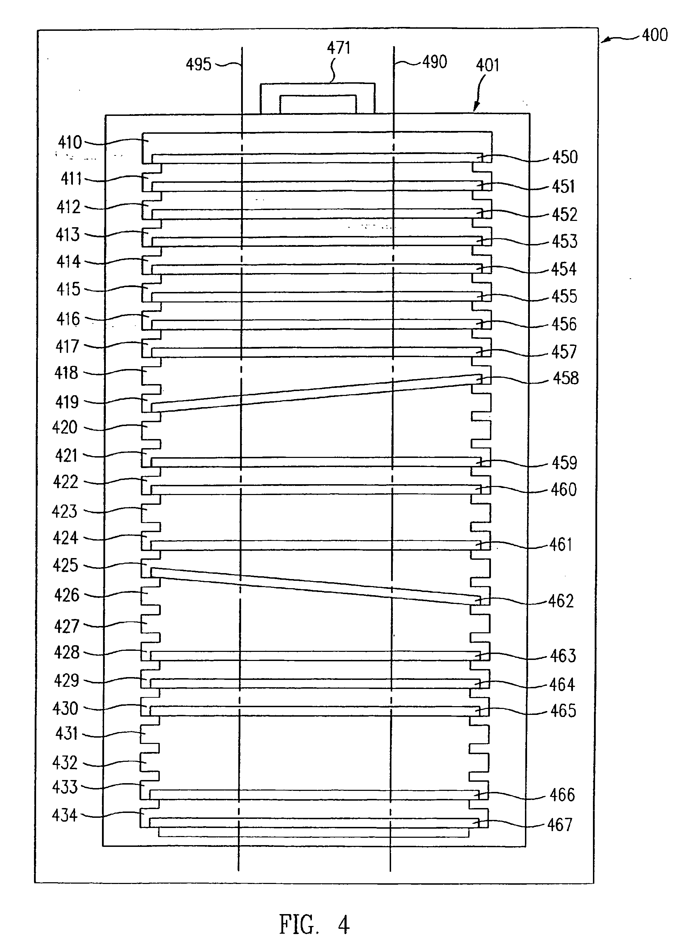

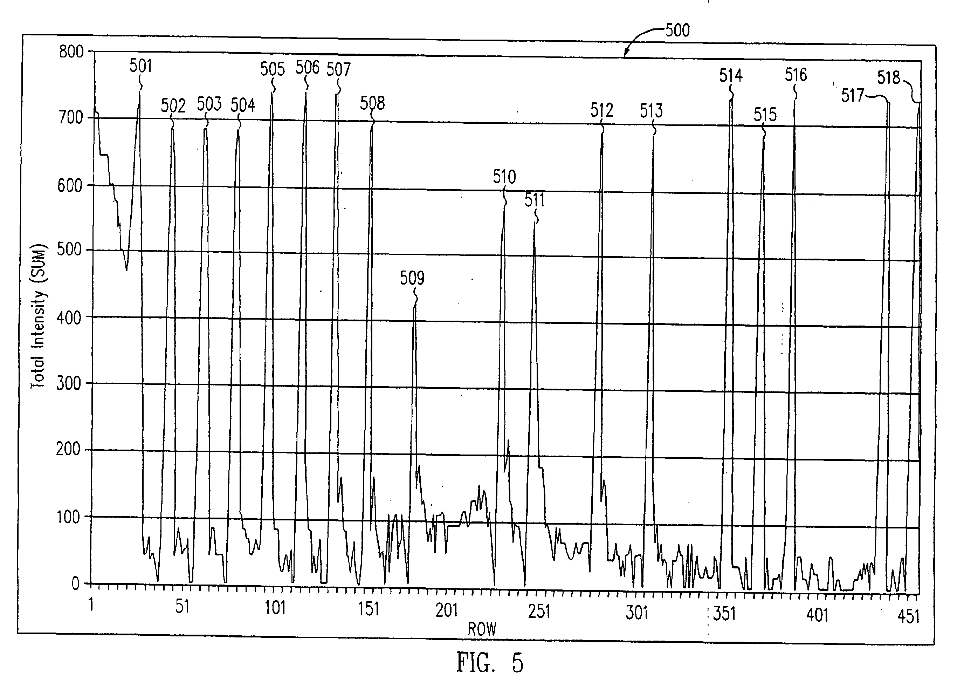

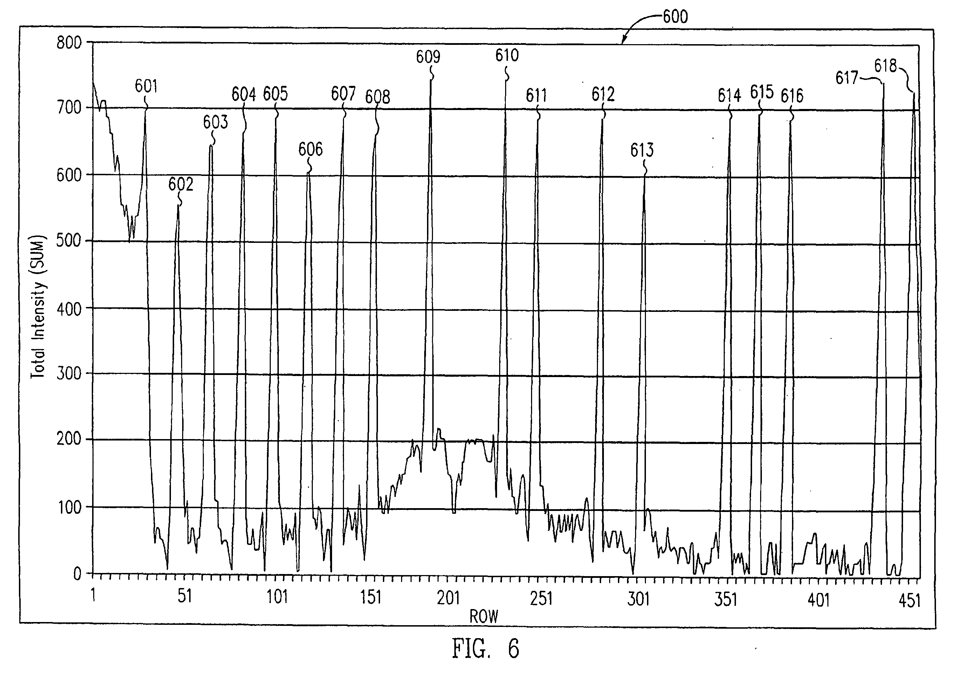

By taking the intensity values of pixels in two rows of an image, a cross-slotted wafer in a carrier can be detected. In FIG. 4, a line 495 and a line 490 represent two columns of an image 400. Image 400 is an image of a carrier 401 which is a 25-slot carrier having slots 410-434. Carrier 401 contains wafers 450-467, of which wafer 458 and wafer 462 are cross-slotted. Table C is a table containing red (R) intensity, green (G) intensity, blue (B) intensity, and total intensity (SUM) of pixels along line 490. A plot 500, shown in FIG. 5, is a plot of the total intensity versus row location for each pixel along line 490. Table C also contains red (R) intensity, green (G) intensity, blue (B) intensity, and total intensity (SUM) of pixels along line 495. A plot of total intensity versus row location for pixels along line 495 is shown in FIG. 6 as plot 600. By detecting peak intensities and by knowing the number of pixel rows between the slots of carrier 401, the presence or absence of a wafer in a specific slot can be determined as described above. Table 1 below shows the correspondence between the wafers in carrier 401 and the peaks in plot 500 and plot 600.

**Table 1**

| WAFER (FIG. 4) | SLOT (FIG. 4) | PEAK (FIG. 5) | PEAK (FIG. 6) |
|---|---|---|---|
| 450 | 410 | 501 | 601 |
| 451 | 411 | 502 | 602 |
| 452 | 412 | 503 | 603 |
| 453 | 413 | 504 | 604 |
| 454 | 414 | 505 | 605 |
| 455 | 415 | 506 | 606 |
| 456 | 416 | 507 | 607 |
| 457 | 417 | 508 | 608 |
| 458 | Cross-slotted between slots 418 and 419 | 509 | 609 |
| 459 | 421 | 510 | 610 |
| 460 | 422 | 511 | 611 |
| 461 | 424 | 512 | 612 |
| 462 | Cross-Slotted between slots 425 and 426 | 513 | 613 |
| 463 | 428 | 514 | 614 |
| 464 | 429 | 515 | 615 |
| 465 | 430 | 516 | 616 |
| 466 | 433 | 517 | 617 |
| 467 | 434 | 518 | 618 |

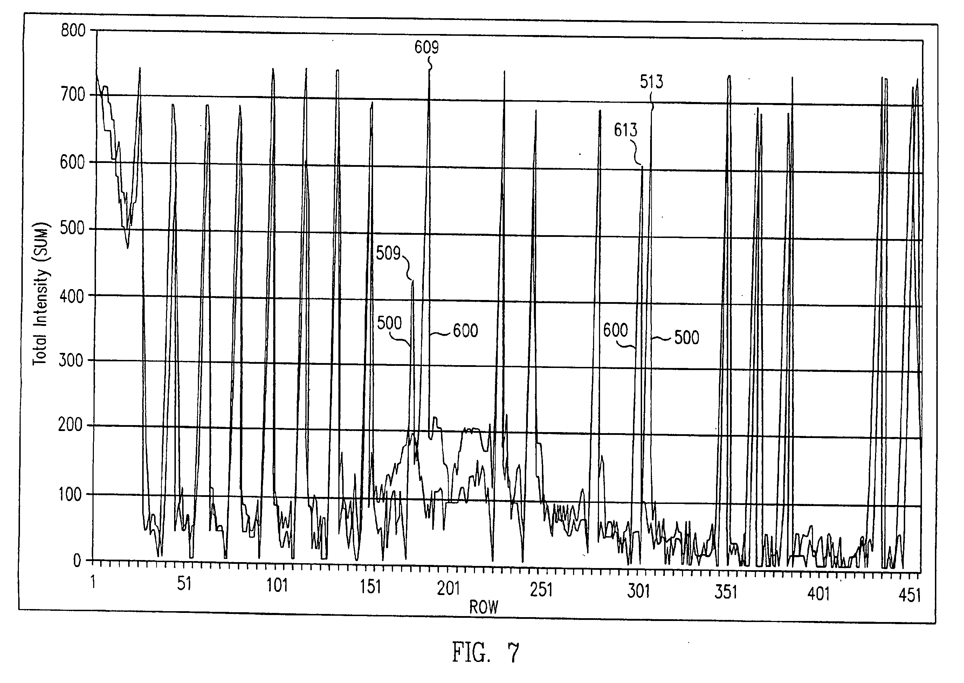

Using the total intensity values of pixels along line 490 and line 495 on image 400 (FIG. 4), cross-slotted wafers are detected by comparing the rows where the peaks occur. As shown in FIG. 7, which shows plot 500 superimposed on plot 600, peaks corresponding to wafers that are not cross-slotted occur at approximately the same row. For cross-slotted wafers, however, the peaks occur at different rows. Peak 509, which corresponds to cross-slotted wafer 458, occurs at row 178 in plot 500 whereas peak 609, which corresponds to the same wafer 458, occurs at row 183 in plot 600. Similarly, for cross-slotted wafer 462, peak 513 occurs at row 308 in plot 500 while peak 613 occurs at row 303 in plot 600. Thus, cross-slotted wafers can be detected by looking for shifts in peak row locations for the same wafer. These shifts can be detected using a variety of conventional methods including by direct comparison of peak row locations. Conventional signal processing techniques may also be used.

Because the invention employs image acquisition and processing techniques, the invention provides a fast wafer mapping system with minimal moving parts. This is in marked contrast with wafer mapping systems in the prior art where each wafer in a carrier is moved vertically to break a laser beam. The invention can also be used to detect cross-slotted wafers, a task which is complicated and requires multiple sensors when conventional laser beam techniques are used. By feeding the output of the wafer mapping camera to a display, an operator can also remotely monitor the status of the wafers in the carrier.

The description of the invention given above is provided for purposes of illustration and is not intended to be limiting. The invention is set forth in the following claims.

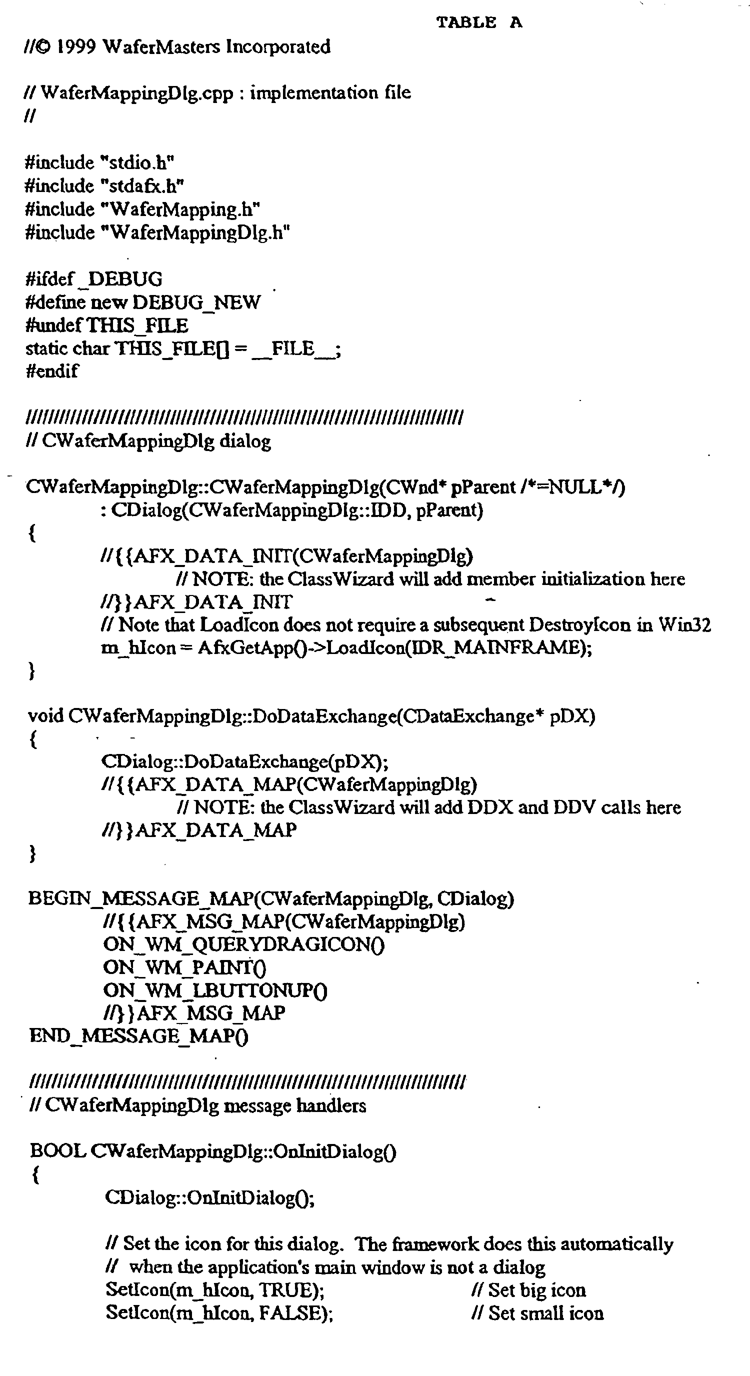

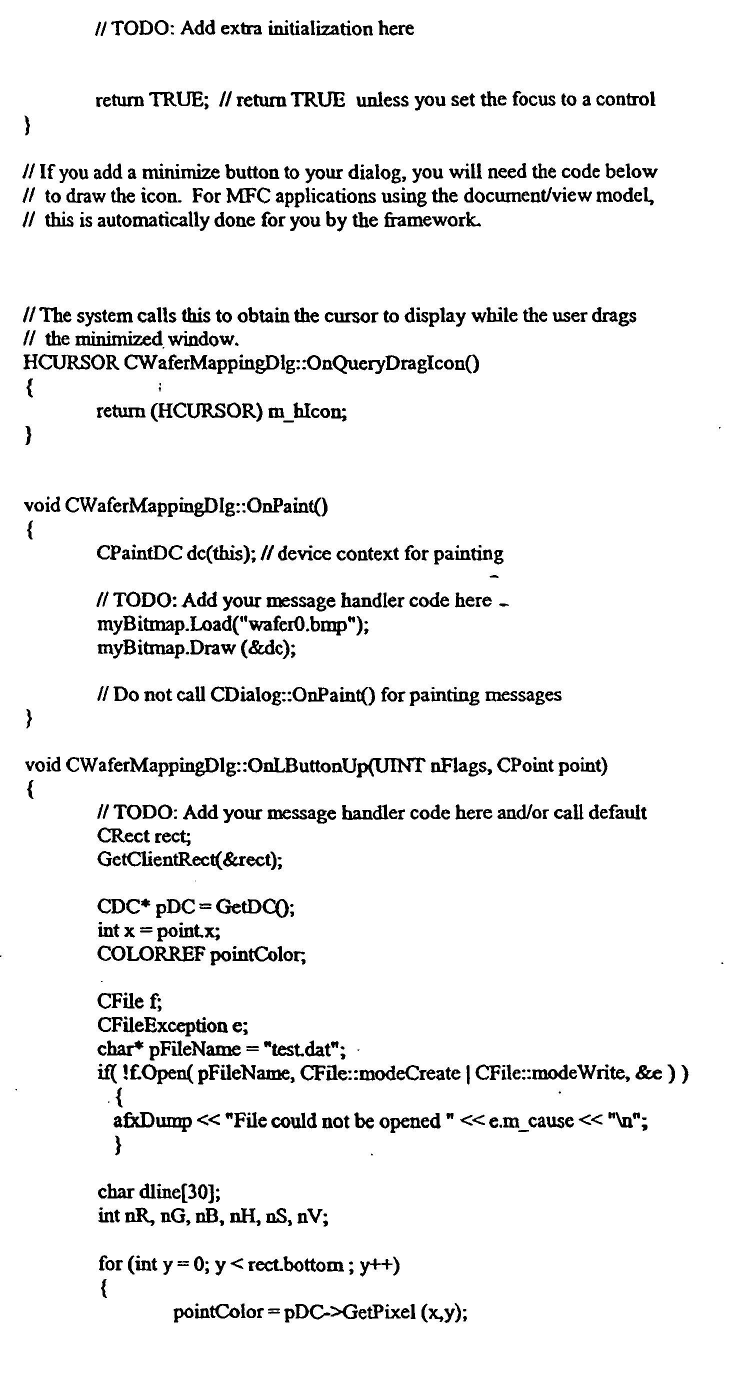

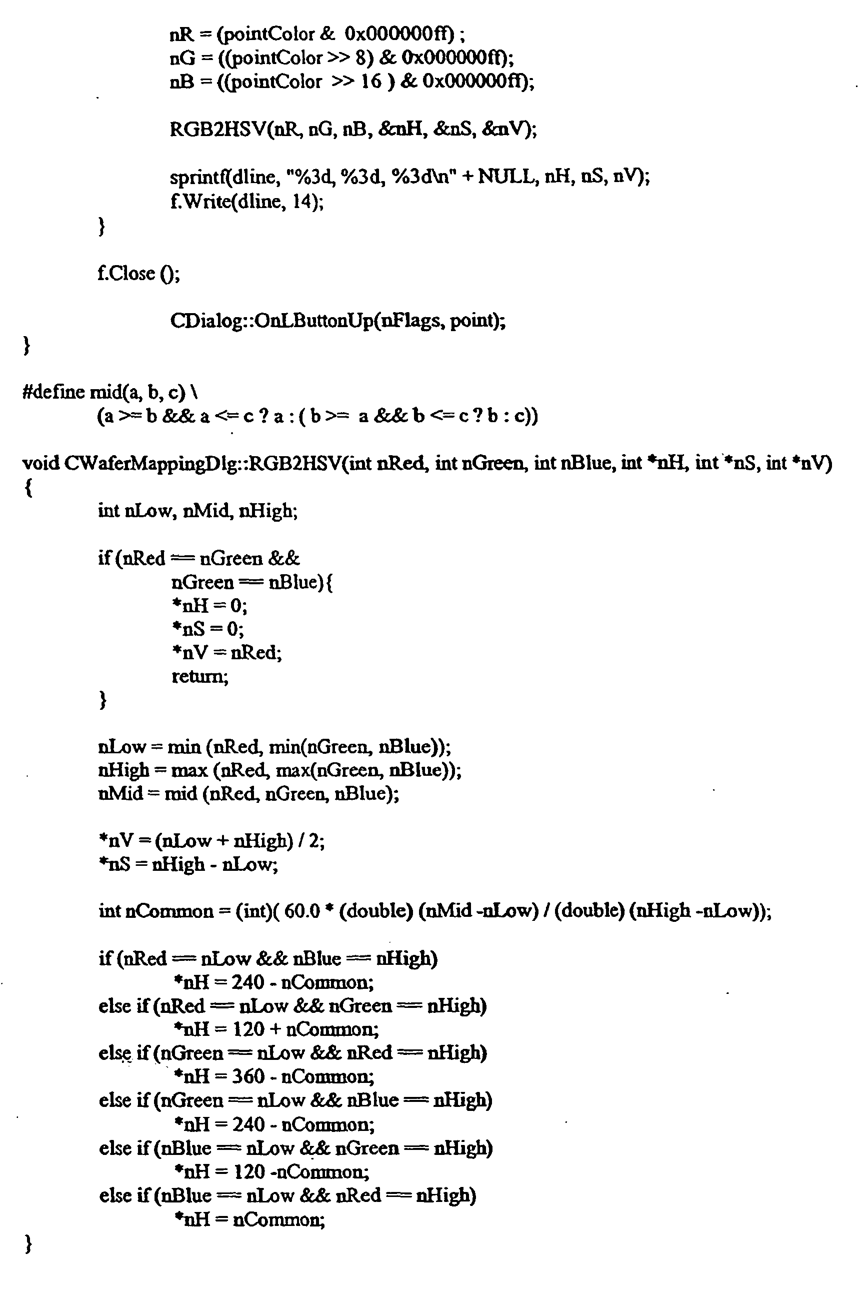

**TABLE B**

| R | G | B | SUM |
|---|---|---|---|
| 173 | 174 | 173 | 520 |
| 156 | 166 | 148 | 470 |
| 173 | 158 | 165 | 496 |
| 173 | 150 | 132 | 455 |
| 173 | 166 | 140 | 479 |
| 173 | 150 | 132 | 455 |
| 173 | 150 | 132 | 455 |
| 173 | 150 | 132 | 455 |
| 173 | 150 | 148 | 471 |
| 173 | 150 | 148 | 471 |
| 173 | 150 | 148 | 471 |
| 173 | 150 | 148 | 471 |
| 156 | 105 | 165 | 426 |
| 206 | 182 | 165 | 553 |
| 214 | 207 | 214 | 635 |
| 247 | 247 | 247 | 741 |
| 247 | 247 | 247 | 741 |
| 247 | 247 | 247 | 741 |
| 247 | 247 | 247 | 741 |
| 231 | 223 | 239 | 693 |
| 189 | 174 | 222 | 585 |
| 115 | 113 | 156 | 384 |
| 57 | 48 | 90 | 195 |
| 49 | 40 | 57 | 146 |
| 41 | 32 | 90 | 163 |
| 41 | 48 | 90 | 179 |
| 49 | 48 | 66 | 163 |
| 33 | 56 | 66 | 155 |
| 49 | 48 | 49 | 146 |
| 57 | 48 | 66 | 171 |
| 66 | 40 | 57 | 163 |
| 66 | 40 | 57 | 163 |
| 74 | 73 | 74 | 221 |
| 33 | 16 | 41 | 90 |
| 33 | 48 | 24 | 105 |
| 198 | 207 | 214 | 619 |
| 247 | 247 | 247 | 741 |
| 247 | 247 | 247 | 741 |
| 231 | 223 | 239 | 693 |
| 231 | 223 | 239 | 693 |
| 198 | 174 | 239 | 611 |
| 140 | 97 | 165 | 402 |
| 66 | 16 | 99 | 181 |
| 66 | 56 | 107 | 229 |
| 74 | 65 | 107 | 246 |
| 74 | 81 | 90 | 245 |
| 74 | 81 | 107 | 262 |
| 74 | 65 | 90 | 229 |
| 74 | 65 | 90 | 229 |
| 57 | 73 | 90 | 220 |
| 74 | 65 | 107 | 246 |
| 74 | 65 | 90 | 229 |
| 57 | 65 | 90 | 212 |
| 33 | 32 | 41 | 106 |
| 33 | 48 | 41 | 122 |
| 198 | 199 | 189 | 586 |
| 247 | 247 | 247 | 741 |
| 247 | 247 | 247 | 741 |
| 247 | 247 | 247 | 741 |
| 231 | 239 | 239 | 709 |
| 198 | 207 | 214 | 619 |
| 132 | 113 | 148 | 393 |
| 57 | 40 | 90 | 187 |
| 66 | 56 | 107 | 229 |
| 74 | 65 | 90 | 229 |
| 74 | 81 | 107 | 262 |
| 90 | 81 | 107 | 278 |
| 74 | 81 | 107 | 262 |
| 74 | 81 | 107 | 262 |
| 74 | 81 | 90 | 245 |
| 74 | 81 | 90 | 245 |
| 74 | 97 | 99 | 270 |
| 90 | 81 | 107 | 278 |
| 49 | 48 | 49 | 146 |
| 57 | 73 | 57 | 187 |
| 181 | 199 | 181 | 561 |
| 231 | 247 | 247 | 725 |
| 247 | 247 | 247 | 741 |
| 247 | 247 | :247 | 741 |
| 247 | 247 | 247 | 741 |
| 231 | 239 | 239 | 709 |
| 156 | 174 | 165 | 495 |
| 57 | 65 | 74 | 196 |
| 74 | 81 | 90 | 245 |
| 90 | 97 | 115 | 302 |
| 74 | 81 | 107 | 262 |
| 57 | 81 | 115 | 253 |
| 90 | 97 | 140 | 327 |
| 90 | 97 | 115 | 302 |
| 90 | 97 | 115 | 302 |
| 90 | 97 | 115 | 302 |
| 90 | 97 | 115 | 302 |
| 90 | 105 | 107 | 302 |
| 57 | 73 | 74 | 204 |
| 49 | 89 | 41 | 179 |
| 198 | 199 | 165 | 562 |
| 214 | 231 | 222 | 667 |
| 247 | 247 | 247 | 741 |
| 231 | 247 | 247 | 725 |
| 231 | 223 | 239 | 693 |
| 173 | 182 | 198 | 553 |
| 115 | 134 | 156 | 405 |
| 74 | 81 | 107 | 262 |
| 74 | 81 | 107 | 262 |
| 57 | 81 | 115 | 253 |
| 90 | 97 | 115 | 302 |
| 74 | 81 | 107 | 262 |
| 74 | 81 | 107 | 262 |
| 90 | 81 | 123 | 294 |
| 74 | 81 | 107 | 262 |
| 90 | 97 | 115 | 302 |
| 90 | 81 | 123 | 294 |
| 90 | 81 | 107 | 278 |
| 57 | 73 | 90 | 220 |
| 74 | 105 | 66 | 245 |
| 90 | 105 | 107 | 302 |
| 156 | 174 | 165 | 495 |
| 231 | 247 | 247 | 725 |
| 247 | 247 | 247 | 741 |
| 231 | 247 | 247 | 725 |
| 214 | 207 | 214 | 635 |
| 156 | 174 | 165 | 495 |
| 74 | 65 | 90 | 229 |
| 74 | 81 | 90 | 245 |
| 74 | 81 | 107 | 262 |
| 74 | 81 | 107 | 262 |
| 74 | 65 | 107 | 246 |
| 57 | 65 | 90 | 212 |
| 57 | 56 | 90 | 203 |
| 57 | 56 | 90 | 203 |
| 57 | 65 | 90 | 212 |
| 57 | 65 | 90 | 212 |
| 57 | 65 | 90 | 212 |
| 16 | 56 | 57 | 129 |
| 16 | 56 | 57 | 129 |
| 49 | 113 | 99 | 261 |
| 140 | 166 | 181 | 487 |
| 231 | 247 | 247 | 725 |
| 231 | 247 | 247 | 725 |
| 231 | 239 | 239 | 709 |
| 173 | 182 | 198 | 553 |
| 140 | 134 | 173 | 447 |
| 41 | 48 | 90 | 179 |
| 33 | 56 | 66 | 155 |
| 41 | 48 | 90 | 179 |
| 49 | 48 | 66 | 163 |
| 41 | 48 | 90 | 179 |
| 57 | 48 | 66 | 171 |
| 33 | 48 | 57 | 138 |
| 49 | 48 | 66 | 163 |
| 33 | 48 | 57 | 138 |
| 49 | 48 | 66 | 163 |
| 57 | 73 | 74 | 204 |
| 33 | 32 | 41 | 106 |
| 16 | 16 | 8 | 40 |
| 99 | 105 | 107 | 311 |
| 173 | 174 | 173 | 520 |
| 239 | 239 | 214 | 692 |
| 231 | 247 | 247 | 725 |
| 214 | 231 | 222 | 667 |
| 74 | 81 | 107 | 262 |
| 33 | 40 | 49 | 122 |
| 33 | 56 | 66 | 155 |
| 41 | 48 | 90 | 179 |
| 41 | 48 | 90 | 179 |
| 16 | 56 | 57 | 129 |
| 24 | 48 | 49 | 121 |
| 33 | 66 | 49 | 138 |
| 33 | 48 | 57 | 138 |
| 33 | 32 | 41 | 106 |
| 33 | 32 | 24 | 89 |
| 33 | 40 | 49 | 122 |
| 16 | 32 | 24 | 72 |
| 16 | 16 | 24 | 56 |
| 16 | 32 | 24 | 72 |
| 173 | 174 | 173 | 520 |
| 247 | 247 | 247 | 741 |
| 247 | 247 | 247 | 741 |
| 231 | 247 | 247 | 725 |
| 214 | 207 | 214 | 635 |
| 57 | 73 | 74 | 204 |
| 0 | 8 | 41 | 49 |
| 24 | 40 | 41 | 105 |
| 33 | 40 | 49 | 122 |
| 33 | 40 | 49 | 122 |
| 24 | 40 | 41 | 105 |
| 16 | 16 | 24 | 56 |
| 24 | 24 | 41 | 89 |
| 16 | 16 | 8 | 40 |
| 16 | 32 | 24 | 72 |
| 16 | 32 | 24 | 72 |
| 16 | 16 | 24 | 56 |
| 16 | 32 | 24 | 72 |
| 16 | 16 | 8 | 40 |
| 33 | 32 | 24 | 89 |
| 181 | 199 | 181 | 561 |
| 247 | 247 | 247 | 741 |
| 247 | 247 | 247 | 741 |
| 247 | 247 | 247 | 741 |
| 206 | 215 | 239 | 660 |
| 57 | 73 | 90 | 220 |
| 0 | 16 | 16 | 32 |
| 24 | 24 | 41 | 89 |
| 24 | 40 | 41 | 105 |
| 8 | 24 | 41 | 73 |
| 0 | 40 | 16 | 56 |
| 8 | 24 | 41 | 73 |
| 0 | 32 | 16 | 48 |
| 0 | 24 | 16 | 40 |
| 16 | 32 | 24 | 72 |
| 24 | 24 | 41 | 89 |
| 0 | 24 | 16 | 40 |
| 0 | 0 | 8 | 8 |
| 74 | 97 | 99 | 270 |
| 173 | 174 | 173 | 520 |
| 231 | 239 | 239 | 709 |
| 247 | 247 | 247 | 741 |
| 247 | 247 | 247 | 741 |
| 115 | 113 | 140 | 368 |
| 0 | 8 | 41 | 49 |
| 8 | 40 | 49 | 97 |
| 16 | 56 | 57 | 129 |
| 8 | 24 | 41 | 73 |
| 8 | 24 | 41 | 73 |
| 0 | 16 | 16 | 32 |
| 0 | 16 | 16 | 32 |
| 16 | 16 | 24 | 56 |
| 16 | 16 | 24 | 56 |
| 16 | 16 | 24 | 56 |
| 0 | 16 | 0 | 16 |
| 0 | 0 | 8 | 8 |
| 0 | 0 | 8 | 8 |
| 0 | 16 | 16 | 32 |
| 115 | 134 | 140 | 389 |
| 247 | 247 | 247 | 741 |
| 247 | 247 | 247 | 741 |
| 239 | 223 | 206 | 668 |
| 198 | 182 | 189 | 569 |
| 132 | 113 | 123 | 368 |
| 33 | 40 | 49 | 122 |
| 8 | 40 | 49 | 97 |
| 8 | 24 | 41 | 73 |
| 8 | 40 | 49 | 97 |
| 8 | 24 | 41 | 73 |
| 0 | 16 | 16 | 32 |
| 0 | 0 | 8 | 8 |
| 16 | 16 | 24 | 56 |
| 16 | 16 | 24 | 56 |
| 16 | 16 | 8 | 40 |
| 16 | 16 | 8 | 40 |
| 0 | 0 | 8 | 8 |
| 16 | 16 | 8 | 40 |
| 0 | 0 | 8 | 8 |
| 140 | 134 | 107 | 381 |
| 247 | 247 | 247 | 741 |
| 239 | 239 | 214 | 692 |
| 173 | 182 | 198 | 553 |
| 33 | 16 | 41 | 90 |
| 33 | 16 6 | 41 | 90 |
| 41 | 48 | 90 | 179 |
| 24 | 24 | 41 | 89 |
| 0 | 8 | 41 | 49 |
| 0 | 8 | 41 | 49 |
| 0 | 0 | 8 | 8 |
| 16 | 16 | 24 | 56 |
| 0 | 0 | 8 | 8 |
| 16 | 16 | 24 | 56 |
| 16 | 16 | 24 | 56 |
| 16 | 16 | 8 | 40 |
| 16 | 16 | 8 | 40 |
| 0 | 0 | 8 | 8 |
| 74 | 73 | 74 | 221 |
| 231 | 231 | 214 | 676 |
| 247 | 247 | 247 | 741 |
| 247 | 247 | 247 | 741 |
| 231 | 231 | 214 | 676 |
| 156 | 158 | 165 | 479 |
| 49 | 24 | 49 | 122 |
| 33 | 16 | 41 | 90 |
| 16 | 16 | 24 | 56 |
| 24 | 24 | 41 | 89 |
| 16 | 16 | 24 | 56 |
| 0 | 16 | 16 | 32 |
| 0 | 16 | 16 | 32 |
| 0 | 0 | 8 | 8 |
| 0 | 16 | 0 | 16 |
| 0 | 16 | 0 | 16 |
| 0 | 16 | 0 | 16 |
| 0 | 0 | 8 | 8 |
| 0 | 0 | 8 | 8 |
| 99 | 113 | 107 | 319 |
| 181 | 199 | 181 | 561 |
| 231 | 247 | 247 | 725 |
| 247 | 247 | 247 | 741 |
| 231 | 223 | 239 | 693 |
| 74 | 81 | 107 | 262 |
| 0 | 0 | 8 | 8 |
| 8 | 24 | 41 | 73 |
| 8 | 24 | 41 | 73 |
| 0 | 8 | 41 | 49 |
| 0 | 16 | 16 | 32 |
| 0 | 0 | 8 | 8 |
| 0 | 0 | 8 | 8 |
| 0 | 0 | 8 | 8 |
| 0 | 16 | 0 | 16 |
| 0 | 16 | 0 | 16 |
| 0 | 0 | 8 | 8 |
| 0 | 0 | 8 | 8 |
| 74 | 73 | 74 | 221 |
| 156 | 166 | 148 | 470 |
| 214 | 231 | 222 | 667 |
| 247 | 247 | 247 | 741 |
| 247 | 247 | 247 | 741 |
| 132 | 113 | 123 | 368 |
| 0 | 8 | 41 | 49 |
| 33 | 32 | 41 | 106 |
| 49 | 48 | 66 | 163 |
| 33 | 40 | 49 | 122 |
| 33 | 40 | 49 | 122 |
| 33 | 32 | 24 | 89 |
| 16 | 16 | 24 | 56 |
| 16 | 16 | 24 | 56 |
| 33 | 32 | 24 | 89 |
| 16 | 32 | 24 | 72 |
| 16 | 16 | 8 | 40 |
| 16 | 16 | 24 | 56 |
| 16 | 16 | 24 | 56 |
| 16 | 16 | 24 | 56 |
| 16 | 16 | 24 | 56 |
| 16 | 32 | 24 | 72 |
| 16 | 16 | 24 | 56 |
| 24 | 24 | 41 | 89 |
| 24 | 24 | 41 | 89 |
| 16 | 32 | 24 | 72 |
| 33 | 16 | 41 | 90 |
| 16 | 16 | 24 | 56 |
| 16 | 32 | 24 | 72 |
| 16 | 32 | 24 | 72 |
| 8 | 24 | 41 | 73 |
| 24 | 40 | 41 | 105 |
| 16 | 32 | 24 | 72 |
| 16 | 16 | 24 | 56 |
| 16 | 32 | 24 | 72 |
| 33 | 40 | 49 | 122 |
| 33 | 48 | 24 | 105 |
| 24 | 40 | 41 | 105 |
| 16 | 16 | 24 | 56 |
| 16 | 16 | 24 | 56 |
| 24 | 24 | 41 | 89 |
| 16 | 16 | 24 | 56 |
| 33 | 32 | 24 | 89 |
| 33 | 16 | 41 | 90 |
| 24 | 24 | 41 | 89 |
| 24 | 24 | 41 | 89 |
| 33 | 32 | 41 | 106 |
| 8 | 24 | 41 | 73 |
| 24 | 24 | 41 | 89 |
| 24 | 24 | 41 | 89 |
| 8 | 24 | 41 | 73 |
| 24 | 24 | 41 | 89 |
| 16 | 32 | 24 | 72 |
| 8 | 24 | 41 | 73 |
| 24 | 48 | 49 | 121 |
| 16 | 32 | 24 | 72 |
| 33 | 40 | 49 | 122 |
| 24 | 40 | 41 | 105 |
| 33 | 32 | 41 | 106 |
| 33 | 40 | 49 | 122 |
| 16 | 32 | 24 | 72 |
| 33 | 40 | 49 | 122 |
| 16 | 16 | 24 | 56 |
| 24 | 24 | 41 | 89 |
| 33 | 40 | 49 | 122 |
| 33 | 32 | 41 | 106 |
| 33 | 40 | 49 | 122 |
| 33 | 32 | 41 | 106 |
| 33 | 32 | 41 | 106 |
| 16 | 32 | 24 | 72 |
| 33 | 40 | 49 | 122 |
| 33 | 48 | 57 | 138 |
| 49 | 48 | 49 | 146 |
| 33 | 48 | 41 | 122 |
| 16 | 32 | 24 | 72 |
| 16 | 16 | 24 | 56 |
| 16 | 16 | 8 | 40 |
| 0 | 16 | 16 | 32 |
| 0 | 0 | 8 | 8 |
| 16 | 16 | 8 | 40 |
| 0 | 0 | 8 | 8 |
| 16 | 16 | 8 | 40 |
| 16 | 16 | 8 | 40 |
| 16 | 16 | 8 | 40 |
| 16 | 16 | 8 | 40 |
| 16 | 16 | 8 | 40 |
| 16 | 16 | 8 | 40 |
| 16 | 16 | 8 | 40 |
| 33 | 16 | 41 | 90 |
| 33 | 16 | 41 | 90 |
| 16 | 16 | 8 | 40 |
| 33 | 16 | 41 | 90 |
| 16 | 16 | 8 | 40 |
| 16 | 16 | 8 | 40 |
| 0 | 32 | 16 | 48 |
| 16 | 32 | 24 | 72 |
| 16 | 32 | 24 | 72 |
| 16 | 16 | 8 | 40 |
| 16 | 16 | 8 | 40 |
| 16 | 16 | 8 | 40 |
| 33 | 32 | 24 | 89 |
| 33 | 32 | 24 | 89 |
| 33 | 32 | 24 | 89 |
| 33 | 32 | 24 | 89 |
| 16 | 16 | 24 | 56 |
| 33 | 16 | 41 | 90 |
| 24 | 24 | 41 | 89 |
| 24 | 24 | 41 | 89 |
| 33 | 32 | 41 | 106 |
| 24 | 24 | 41 | 89 |
| 33 | 32 | 41 | 106 |
| 33 | 32 | 24 | 89 |
| 16 | 32 | 24 | 72 |
| 33 | 32 | 24 | 89 |
| 33 | 40 | 49 | 122 |
| 33 | 32 | 24 | 89 |
| 33 | 32 | 24 | 89 |
| 33 | 32 | 24 | 89 |
| 16 | 32 | 24 | 72 |
| 33 | 32 | 24 | 89 |
| 33 | 32 | 24 | 89 |
| 33 | 32 | 24 | 89 |
| 16 | 32 | 24 | 72 |
| 33 | 40 | 49 | 122 |
| 33 | 32 | 24 | 89 |
| 16 | 32 | 24 | 72 |
| 33 | 40 | 24 | 97 |
| 16 | 16 | 8 | 40 |
| 16 | 32 | 24 | 72 |
| 33 | 32 | 24 | 89 |
| 33 | 32 | 24 | 89 |
| 33 | 32 | 24 | 89 |
| 33 | 40 | 49 | 122 |
| 33 | 32 | 41 | 106 |
| 33 | 40 | 24 | 97 |
| 16 | 16 | 8 | 40 |
| 0 | 0 | 8 | 8 |
| 74 | 73 | 74 | 221 |
| 140 | 150 | 148 | 438 |
| 222 | 239 | 247 | 708 |
| 247 | 247 | 247 | 741 |
| 231 | 247 | 247 | 725 |
| 247 | 247 | 247 | 741 |
| 181 | 199 | 181 | 561 |
| 33 | 56 | 49 | 138 |
| 0 | 0 | 8 | 8 |
| 0 | 16 | 0 | 16 |
| 0 | 0 | 8 | 8 |
| 0 | 0 | 8 | 8 |
| 0 | 0 | 8 | 8 |
| 16 | 16 | 24 | 56 |
| 0 | 0 | 8 | 8 |
| 0 | 0 | 8 | 8 |
| 16 | 32 | 24 | 72 |
| 115 | 105 | 123 | 343 |
| 181 | 199 | 181 | 561 |
| 247 | 247 | 247 | 741 |
| 247 | 247 | 247 | 741 |
| 247 | 247 | 247 | 741 |
| 247 | 247 | 247 | 741 |
| 140 | 150 | 148 | 438 |
| 0 | 0 | 8 | 8 |
| 57 | 81 | 107 | 245 |
| 99 | 113 | 140 | 352 |
| 99 | 113 | 140 | 352 |
| 99 | 113 | 140 | 352 |
| 115 | 134 | 140 | 369 |
| 115 | 134 | 156 | 405 |
| 115 | 134 | 156 | 405 |
| 115 | 134 | 156 | 405 |
| 132 | 134 | 148 | 414 |
| 115 | 134 | 156 | 405 |
| 198 | 195 | 198 | 591 |
| 198 | 195 | 198 | 591 |
| 198 | 195 | 198 | 591 |
| 198 | 195 | 198 | 591 |
| 198 | 195 | 198 | 591 |
| 198 | 195 | 198 | 591 |
| 198 | 195 | 198 | 591 |
| 198 | 195 | 198 | 591 |
| 198 | 195 | 198 | 591 |
| 198 | 195 | 198 | 591 |
| 198 | 195 | 198 | 591 |
| 198 | 195 | 198 | 591 |
| 198 | 195 | 198 | 591 |
| 198 | 195 | 198 | 591 |
| 198 | 195 | 198 | 591 |
| 198 | 195 | 198 | 591 |
| 198 | 195 | 198 | 591 |
| 198 | 195 | 198 | 591 |
| 198 | 195 | 198 | 591 |
| 198 | 195 | 198 | 591 |
| 198 | 195 | 198 | 591 |
| 198 | 195 | 198 | 591 |
| 198 | 195 | 198 | 591 |
| 198 | 195 | 198 | 591 |
| 198 | 195 | 198 | 591 |
| 198 | 195 | 198 | 591 |
| 198 | 195 | 198 | 591 |
| 198 | 195 | 198 | 591 |
| 198 | 195 | 198 | 591 |
| 198 | 195 | 198 | 591 |
| 198 | 195 | 198 | 591 |
| 198 | 195 | 198 | 591 |
| 198 | 195 | 198 | 591 |
| 198 | 195 | 198 | 591 |
| 198 | 195 | 198 | 591 |
| 198 | 195 | 198 | 591 |
| 198 | 195 | 198 | 591 |
| 198 | 195 | 198 | 591 |
| 198 | 195 | 198 | 591 |
| 198 | 195 | 198 | 591 |
| 198 | 195 | 198 | 591 |
| 198 | 195 | 198 | 591 |
| | | | |
| | | | |

**TABLE C**

| LINE 490 | | | | | LINE 495 | | | |
|---|---|---|---|---|---|---|---|---|
| R | G | B | SUM | | R | G | B | SUM |
| 231 | 247 | 247 | 725 | | 231 | 247 | 247 | 725 |
| 222 | 239 | 247 | 708 | | 222 | 239 | 247 | 708 |
| 222 | 239 | 247 | 708 | | 206 | 239 | 247 | 692 |
| 222 | 215 | 247 | 684 | | 222 | 239 | 247 | 708 |
| 206 | 199 | 239 | 644 | | 222 | 239 | 247 | 708- |
| 206 | 199 | 239 | 644 | | 222 | 239 | 247 | 708 |
| 206 | 199 | 239 | 644 | | 222 | 215 | 247 | 684 |
| 206 | 199 | 239 | 644 | | 222 | 215 | 247 | 684 |
| 206 | 199 | 239 | 644 | | 206 | 215 | 239 | 660 |
| 198 | 190 | 214 | 602 | | 206 | 215 | 239 | 660 |
| 198 | 190 | 214 | 602 | | 206 | 199 | 239 | 644 |
| 198 | 190 | 214 | 602 | | 198 | 190 | 214 | 602 |
| 189 | 199 | 189 | 577 | | 206 | 207 | 214 | 627 |
| 189 | 199 | 189 | 577 | | 198 | 190 | 214 | 602 |
| 189 | 182 | 165 | 536 | | 189 | 182 | 181 | 552 |
| 165 | 190 | 189 | 544 | | 189 | 182 | 181 | 552 |
| 181 | 174 | 148 | 503 | | 189 | 182 | 165 | 536 |
| 181 | 174 | 148 | 503 | | 189 | 182 | 181 | 552 |
| 148 | 182 | 165 | 495 | | 198 | 182 | 148 | 528 |
| 165 | 166 | 140 | 471 | | 165 | 150 | 181 | 496 |
| 148 | 166 | 181 | 495 | | 189 | 182 | 165 | 536 |
| 189 | 182 | 181 | 552 | | 181 | 174 | 148 | 503 |
| 198 | 190 | 214 | 602 | | 189 | 182 | 165 | 536 |
| 222 | 215 | 247 | 684 | | 189 | 182 | 165 | 536 |
| 247 | 247 | 247 | 741 | | 189 | 199 | 189 | 577 |
| 222 | 215 | 247 | 684 | | 206 | 239 | 247 | 692 |
| 206 | 199 | 239 | 644 | | 206 | 207 | 214 | 627 |
| 173 | 166 | 206 | 545 | | 165 | 174 | 189 | 528 |
| 107 | 97 | 132 | 336 | | 123 | 134 | 173 | 430 |
| 49 | 56 | 82 | 187 | | 74 | 89 | 115 | 278 |
| 8 | 32 | 33 | 73 | | 24 | 65 | 90 | 179 |
| 0 | 24 | 24 | 48 | | 8 | 56 | 82 | 146 |
| 0 | 16 | 33 | 49 | | 24 | 16 | 49 | 89 |
| 8 | 32 | 33 | 73 | | 0 | 16 | 33 | 49 |
| 0 | 32 | 8 | 40 | | 8 | 32 | 33 | 73 |
| 0 | 24 | 24 | 48 | | 8 | 32 | 33 | 73 |
| 0 | 24 | 24 | 48 | | 8 | 24 | 24 | 56 |
| 0 | 16 | 8 | 24 | | 8 | 24 | 24 | 56 |
| 0 | 8 | 0 | 8 | | 8 | 32 | 8 | 48 |
| 8 | 24 | 24 | 56 | | 0 | 16 | 8 | 24 |
| 90 | 73 | 90 | 253 | | 0 | 8 | 0 | 8 |
| 165 | 174 | 173 | 512 | | 41 | 40 | 41 | 122 |
| 222 | 215 | 247 | 684 | | 123 | 113 | 140 | 376 |
| 222 | 231 | 231 | 684 | | 165 | 174 | 173 | 512 |
| 206 | 199 | 239 | 644 | | 181 | 166 | 206 | 553 |
| 156 | 142 | 181 | 479 | | 140 | 134 | 173 | 447 |
| 74 | 105 | 123 | 302 | | 107 | 113 | 165 | 385 |
| 0 | 16 | 33 | 49 | | 74 | 48 | 123 | 245 |
| 8 | 32 | 33 | 73 | | 8 | 56 | 82 | 146 |
| 8 | 32 | 49 | 89 | | 24 | 16 | 49 | 89 |
| 8 | 32 | 33 | 73 | | 8 | 40 | 66 | 114 |
| 0 | 16 | 33 | 49 | | 0 | 16 | 33 | 49 |
| 8 | 24 | 24 | 56 | | 0 | 16 | 33 | 49 |
| 8 | 16 | 33 | 57 | | 8 | 32 | 33 | 73 |
| 24 | 24 | 24 | 72 | | 8 | 32 | 33 | 73 |
| 0 | 8 | 0 | 8 | | 0 | 8 | 24 | 32 |
| 0 | 8 | 0 | 8 | | 8 | 24 | 24 | 56 |
| 0 | 8 | 0 | 8 | | 8 | 24 | 24 | 56 |
| 90 | 97 | 107 | 294 | | 24 | 24 | 24 | 72 |
| 206 | 207 | 181 | 594 | | 49 | 56 | 82 | 187 |
| 222 | 231 | 231 | 684 | | 165 | 150 | 181 | 496 |
| 222 | 231 | 231 | 684 | | 206 | 199 | 239 | 644 |
| 181 | 215 | 239 | 635 | | 206 | 199 | 239 | 644 |
| 74 | 89 | 115 | 278 | | 140 | 134 | 173 | 447 |
| 24 | 65 | 90 | 179 | | 107 | 89 | 165 | 361 |
| 8 | 40 | 66 | 114 | | 66 | 32 | 115 | 213 |
| 0 | 16 | 33 | 49 | | 8 | 40 | 66 | 114 |
| 8 | 32 | 49 | 89 | | 8 | 40 | 66 | 114 |
| 8 | 32 | 49 | 89 | | 8 | 32 | 33 | 73 |
| 0 | 16 | 33 | 49 | | 8 | 32 | 33 | 73 |
| 0 | 24 | 24 | 48 | | 0 | 24 | 24 | 48 |
| 0 | 24 | 24 | 48 | | 8 | 24 | 24 | 56 |
| 0 | 24 | 24 | 48 | | 8 | 24 | 24 | 56 |
| 0 | 24 | 24 | 48 | | 8 | 32 | 8 | 48 |
| 0 | 8 | 0 | 8 | | 0 | 16 | 8 | 24 |
| 0 | 8 | 0 | 8 | | 0 | 8 | 0 | 8 |
| 49 | 73 | 82 | 204 | | 24 | 40 | 33 | 97 |
| 206 | 207 | 214 | 627 | | 66 | 73 | 66 | 205 |
| 222 | 231 | 231 | 684 | | 148 | 166 | 181 | 495 |
| 206 | 215 | 239 | 660 | | 206 | 215 | 239 | 660 |
| 181 | 182 | 206 | 569 | | 173 | 166 | 206 | 545 |
| 115 | 97 | 132 | 344 | | 123 | 134 | 173 | 430 |
| 8 | 40 | 66 | 114 | | 107 | 89 | 165 | 361 |
| 8 | 40 | 66 | 114 | | 24 | 32 | 49 | 105 |
| 8 | 32 | 49 | 89 | | 0 | 16 | 33 | 49 |
| 8 | 32 | 49 | 89 | | 0 | 16 | 33 | 49 |
| 8 | 32 | 33 | 73 | | 0 | 16 | 33 | 49 |
| 8 | 32 | 33 | 73 | | 8 | 32 | 33 | 73 |
| 0 | 16 | 33 | 49 | | 0 | 32 | 8 | 40 |
| 0 | 16 | 33 | 49 | | 0 | 32 | 8 | 40 |
| 8 | 16 | 33 | 57 | | 0 | 32 | 8 | 40 |
| 24 | 24 | 24 | 72 | | 8 | 40 | 8 | 56 |
| 8 | 16 | 33 | 57 | | 24 | 40 | 33 | 97 |
| 8 | 24 | 24 | 56 | | 0 | 8 | 0 | 8 |
| 24 | 40 | 33 | 97 | | 8 | 32 | 8 | 48 |
| 189 | 182 | 181 | 552 | | 90 | 89 | 90 | 269 |
| 247 | 247 | 247 | 741 | | 148 | 166 | 181 | 495 |
| 231 | 247 | 247 | 725 | | 222 | 231 | 231 | 684 |
| 165 | 174 | 173 | 512 | | 165 | 190 | 189 | 544 |
| 90 | 97 | 107 | 294 | | 123 | 150 | 165 | 438 |
| 8 | 65 | 90 | 163 | | 24 | 73 | 90 | 187 |
| 8 | 32 | 49 | 89 | | 8 | 40 | 66 | 114 |
| 8 | 32 | 49 | 89 | | 8 | 48 | 49 | 105 |
| 8 | 32 | 49 | 89 | | 8 | 32 | 33 | 73 |
| 0 | 32 | 8 | 40 | | 0 | 24 | 24 | 48 |
| 0 | 16 | 8 | 24 | | 16 | 56 | 8 | 80 |
| 0 | 16 | 8 | 24 | | 8 | 24 | 24 | 56 |
| 0 | 24 | 24 | 48 | | 8 | 32 | 33 | 73 |
| 0 | 24 | 24 | 48 | | 8 | 24 | 24 | 56 |
| 0 | 16 | 8 | 24 | | 8 | 24 | 24 | 56 |
| 8 | 24 | 24 | 56 | | 24 | 40 | 33 | 97 |
| 0 | 8 | 0 | 8 | | 0 | 8 | 0 | 8 |
| 0 | 8 | 0 | 8 | | 0 | 8 | 0 | 8 |
| 115 | 121 | 115 | 351 | | 57 | 56 | 66 | 179 |
| 222 | 215 | 247 | 684 | | 140 | 134 | 107 | 381 |
| 247 | 247 | 247 | 741 | | 198 | 190 | 214 | 602 |
| 181 | 199 | 214 | 594 | | 198 | 190 | 214 | 602 |
| 107 | 113 | 165 | 385 | | 156 | 174 | 206 | 536 |
| 24 | 65 | 90 | 179 | | 74 | 48 | 123 | 245 |
| 8 | 56 | 82 | 146 | | 49 | 16 | 82 | 147 |
| 8 | 32 | 49 | 89 | | 8 | 32 | 49 | 89 |
| 8 | 32 | 49 | 89 | | 8 | 32 | 49 | 89 |
| 0 | 16 | 8 | 24 | | 8 | 32 | 33 | 73 |
| 0 | 24 | 24 | 48 | | 8 | 48 | 49 | 105 |
| 0 | 16 | 8 | 24 | | 24 | 40 | 33 | 97 |
| 0 | 16 | 8 | 24 | | 8 | 24 | 24 | 56 |
| 24 | 24 | 24 | 72 | | 0 | 16 | 8 | 24 |
| 0 | 8 | 0 | 8 | | 8 | 32 | 8 | 48 |
| 0 | 8 | 0 | 8 | | 24 | 24 | 24 | 72 |
| 0 | 8 | 0 | 8 | | 24 | 24 | 24 | 72 |
| 0 | 8 | 0 | 8 | | 0 | 8 | 08 | 8 |
| 74 | 89 | 66 | 229 | | 57 | 40 | 66 | 163 |
| 247 | 247 | 247 | 741 | | 165 | 174 | 173 | 512 |
| 247 | 247 | 247 | 741 | | 206 | 199 | 181 | 586 |
| 206 | 207 | 214 | 627 | | 222 | 231 | 231 | 684 |
| 99 | 73 | 99 | 271 | | 156 | 150 | 165 | 471 |
| 24 | 40 | 66 | 130 | | 74 | 89 | 90 | 253 |
| 49 | 32 | 90 | 171 | | 0 | 24 | 24 | 48 |
| 8 | 40 | 66 | 114 | | 8 | 32 | 33 | 73 |
| 24 | 16 | 49 | 89 | | 8 | 48 | 49 | 105 |
| 8 | 32 | 49 | 89 | | 24 | 40 | 33 | 97 |
| 0 | 16 | 33 | 49 | | 8 | 32 | 33 | 73 |
| 0 | 24 | 24 | 48 | | 24 | 24 | 24 | 72 |
| 0 | 16 | 8 | 24 | | 24 | 40 | 33 | 97 |
| 0 | 32 | 8 | 40 | | 8 | 40 | 8 | 56 |
| 8 | 32 | 33 | 73 | | 41 | 56 | 41 | 138 |
| 0 | 16 | 8 | 24 | | 24 | 40 | 33 | 97 |
| 0 | 8 | 0 | 8 | | 8 | 32 | 33 | 73 |
| 0 | 8 | 0 | 8 | | 0 | 16 | 8 | 24 |
| 24 | 40 | 33 | 97 | | 8 | 24 | 24 | 56 |
| 189 | 182 | 165 | 536 | | 148 | 166 | 181 | 495 |
| 222 | 231 | 231 | 684 | | 206 | 207 | 214 | 627 |
| 206 | 239 | 247 | 692 | | 206 | 215 | 239 | 660 |
| 115 | 97 | 132 | 344 | | 123 | 134 | 140 | 397 |
| 8 | 32 | 49 | 89 | | 74 | 89 | 115 | 278 |
| 49 | 40 | 82 | 171 | | 49 | 40 | 82 | 171 |
| 24 | 40 | 66 | 130 | | 24 | 32 | 49 | 105 |
| 8 | 32 | 49 | 89 | | 24 | 48 | 49 | 121 |
| 8 | 32 | 33 | 73 | | 24 | 40 | 33 | 97 |
| 0 | 24 | 24 | 48 | | 24 | 40 | 33 | 97 |
| 8 | 24 | 24 | 56 | | 41 | 40 | 41 | 122 |
| 8 | 24 | 24 | 56 | | 24 | 40 | 33 | 97 |
| 0 | 8 | 0 | 8 | | 41 | 40 | 41 | 122 |
| 41 | 32 | 41 | 114 | | 41 | 56 | 41 | 138 |
| 0 | 16 | 8 | 24 | | 41 | 56 | 41 | 138 |
| 8 | 40 | 8 | 56 | | 41 | 40 | 41 | 122 |
| 24 | 40 | 33 | 97 | | 41 | 56 | 41 | 138 |
| 41 | 32 | 41 | 114 | | 41 | 56 | 57 | 154 |
| 41 | 32 | 41 | 114 | | 41 | 56 | 41 | 138 |
| 8 | 32 | 8 | 48 | | 41 | 56 | 57 | 154 |
| 24 | 24 | 24 | 72 | | 41 | 56 | 57 | 154 |
| 41 | 32 | 41 | 114 | | 41 | 65 | 66 | 172 |
| 24 | 24 | 24 | 72 | | 57 | 56 | 66 | 179 |
| 8 | 24 | 24 | 56 | | 57 | 56 | 66 | 179 |
| 0 | 8 | 0 | 8 | | 66 | 56 | 82 | 204 |
| 99 | 121 | 99 | 319 | | 57 | 56 | 66 | 179 |
| 140 | 142 | 140 | 422 | | 74 | 40 | 82 | 196 |
| 148 | 142 | 140 | 430 | | 74 | 40 | 82 | 196 |
| 90 | 97 | 107 | 294 | | 74 | 24 | 90 | 188 |
| 41 | 56 | 57 | 154 | | 66 | 8 | 82 | 156 |
| 49 | 56 | 82 | 187 | | 66 | 56 | 82 | 204 |
| 41 | 56 | 57 | 154 | | 140 | 105 | 140 | 385 |
| 41 | 32 | 57 | 130 | | 247 | 247 | 247 | 741 |
| 41 | 40 | 57 | 138 | | 206 | 215 | 239 | 660 |
| 24 | 40 | 33 | 97 | | 181 | 150 | 214 | 545 |
| 24 | 24 | 24 | 72 | | 90 | 73 | 115 | 278 |
| 24 | 40 | 33 | 97 | | 49 | 56 | 82 | 187 |
| 24 | 24 | 24 | 72 | | 49 | 56 | 82 | 187 |
| 41 | 32 | 41 | 114 | | 57 | 73 | 90 | 220 |
| 8 | 40 | 8 | 56 | | 57 | 73 | 90 | 220 |
| 41 | 32 | 41 | 114 | | 49 | 73 | 82 | 204 |
| 41 | 32 | 41 | 114 | | 49 | 73 | 82 | 204 |
| 41 | 32 | 41 | 114 | | 66 | 73 | 66 | 205 |
| 41 | 40 | 41 | 122 | | 41 | 65 | 66 | 172 |
| 41 | 32 | 41 | 114 | | 41 | 56 | 57 | 154 |
| 8 | 40 | 8 | 56 | | 41 | 56 | 57 | 154 |
| 24 | 40 | 33 | 97 | | 41 | 65 | 41 | 147 |
| 24 | 40 | 33 | 97 | | 24 | 40 | 33 | 97 |
| 24 | 40 | 33 | 97 | | 24 | 40 | 33 | 97 |
| 24 | 40 | 33 | 97 | | 41 | 56 | 41 | 138 |
| 24 | 40 | 33 | 97 | | 41 | 56 | 57 | 154 |
| 24 | 40 | 33 | 97 | | 41 | 56 | 41 | 138 |
| 24 | 40 | 33 | 97 | | 41 | 65 | 66 | 172 |
| 24 | 40 | 33 | 97 | | 41 | 65 | 66 | 172 |
| 24 | 48 | -49 | 121 | | 57 | 73 | 66 | 196 |
| 24 | 48 | 49 | 121 | | 66 | 73 | 66 | 205 |
| 24 | 48 | 49 | 121 | | 57 | 73 | 66 | 196 |
| 24 | 40 | 33 | 97 | | 49 | 73 | 82 | 204 |
| 24 | 40 | 33 | 97 | | 49 | 73 | 82 | 204 |
| 41 | 56 | 41 | 138 | | 57 | 73 | 66 | 196 |
| 41 | 56 | 41 | 138 | | 66 | 56 | 82 | 204 |
| 41 | 56 | 41 | 138 | | 66 | 73 | 66 | 205 |
| 41 | 40 | 41 | 122 | | 49 | 73 | 82 | 204 |
| 57 | 56 | 49 | 162 | | 49 | 73 | 82 | 204 |
| 41 | 40 | 41 | 122 | | 57 | 73 | 66 | 196 |
| 41 | 40 | 57 | 138 | | 57 | 56 | 66 | 179 |
| 41 | 56 | 57 | 154 | | 41 | 65 | 66 | 172 |
| 41 | 40 | 57 | 138 | | 41 | 65 | 66 | 172 |
| 24 | 40 | 33 | 97 | | 41 | 65 | 66 | 172 |
| 24 | 48 | 49 | 121 | | 57 | 89 | 66 | 212 |
| 24 | 40 | 33 | 97 | | 41 | 65 | 66 | 172 |
| 8 | 24 | 24 | 56 | | 24 | 48 | 49 | 121 |
| 0 | 8 | 0 | 8 | | 41 | 65 | 66 | 172 |
| 74 | 97 | 99 | 270 | | 132 | 166 | 165 | 463 |
| 165 | 174 | 173 | 512 | | 247 | 247 | 247 | 741 |
| 189 | 199 | 189 | 577 | | 206 | 207 | 181 | 594 |
| 165 | 174 | 173 | 512 | | 123 | 150 | 165 | 438 |
| 57 | 56 | 66 | 179 | | 24 | 65 | 66 | 155 |
| 49 | 56 | 82 | 187 | | 8 | 56 | 66 | 130 |
| 74 | 56 | 99 | 229 | | 8 | 65 | 90 | 163 |
| 41 | 40 | 57 | 138 | | 24 | 48 | 49 | 121 |
| 24 | 40 | 66 | 130 | | 24 | 48 | 49 | 121 |
| 8 | 32 | 33 | 73 | | 24 | 40 | 33 | 97 |
| 24 | 32 | 49 | 105 | | 24 | 40 | 33 | 97 |
| 24 | 40 | 33 | 97 | | 24 | 48 | 49 | 121 |
| 24 | 40 | 33 | 97 | | 41 | 65 | 41 | 147 |
| 24 | 40 | 33 | 97 | | 41 | 56 | 57 | 154 |
| 24 | 24 | 24 | 72 | | 41 | 40 | 57 | 138 |
| 8 | 24 | 24 | 56 | | 24 | 24 | 24 | 72 |
| 0 | 8 | 0 | 8 | | 8 | 16 | 33 | 57 |
| 41 | 40 | 41 | 122 | | 115 | 121 | 115 | 351 |
| 107 | 97 | 90 | 294 | | 189 | 182 | 181 | 552 |
| 189 | 182 | 181 | 552 | | 222 | 215 | 247 | 684 |
| 156 | 150 | 165 | 471 | | 189 | 182 | 181 | 552 |
| 140 | 105 | 140 | 385 | | 90 | 73 | 99 | 262 |
| 99 | 56 | 115 | 270 | | 57 | 40 | 66 | 163 |
| 49 | 56 | 82 | 187 | | 41 | 40 | 57 | 138 |
| 49 | 56 | 82 | 187 | | 41 | 40 | 57 | 138 |
| 49 | 56 | 82 | 187 | | 24 | 40 | 33 | 97 |
| 49 | 40 | 82 | 171 | | 24 | 32 | 49 | 105 |
| 24 | 40 | 33 | 97 | | 41 | 32 | 41 | 114 |
| 24 | 32 | 49 | 105 | | 24 | 24 | 24 | 72 |
| 24 | 40 | 33 | 97 | | 24 | 40 | 33 | 97 |
| 24 | 24 | 24 | 72 | | 24 | 40 | 33 | 97 |
| 8 | 24 | 24 | 56 | | 8 | 24 | 24 | 56 |
| 8 | 32 | 8 | 48 | | 24 | 24 | 24 | 72 |
| 24 | 40 | 33 | 97 | | 24 | 40 | 33 | 97 |
| 24 | 24 | 24 | 72 | | 24 | 24 | 24 | 72 |
| 24 | 40 | 33 | 97 | | 24 | 24 | 24 | 72 |
| 8 | 32 | 33 | 73 | | 24 | 40 | 33 | 97 |
| 24 | 24 | 24 | 72 | | 24 | 24 | 24 | 72 |
| 8 | 32 | 33 | 73 | | 24 | 40 | 33 | 97 |
| 8 | 16 | 33 | 57 | | 24 | 24 | 24 | 72 |
| 8 | 24 | 24 | 56 | | 24 | 40 | 33 | 97 |
| 0 | 24 | 24 | 48 | | 8 | 24 | 24 | 56 |
| 0 | 24 | 24 | 48 | | 24 | 24 | 24 | 72 |
| 8 | 24 | 24 | 56 | | 24 | 40 | 33 | 97 |
| 8 | 32 | 33 | 73 | | 24 | 40 | 33 | 97 |
| 8 | 16 | 33 | 57 | | 8 | 32 | 33 | 73 |
| 8 | 24 | 24 | 56 | | 24 | 24 | 24 | 72 |
| 8 | 24 | 24 | 56 | | 24 | 40 | 33 | 97 |
| 8 | 32 | 33 | 73 | | 24 | 48 | 49 | 121 |
| 24 | 24 | 24 | 72 | | 24 | 48 | 49 | 121 |
| 8 | 32 | 33 | 73 | | 8 | 32 | 33 | 73 |
| 8 | 32 | 33 | 73 | | 0 | 24 | 24 | 48 |
| 0 | 8 | 24 | 32 | | 0 | 16 | 8 | 24 |
| 57 | 56 | 66 | 179 | | 49 | 113 | 90 | 252 |
| 165 | 174 | 189 | 528 | | 222 | 215 | 206 | 643 |
| 222 | 231 | 231 | 684 | | 222 | 231 | 231 | 684 |
| 222 | 231 | 231 | 684 | | 189 | 199 | 189 | 577 |
| 90 | 97 | 107 | 294 | | 66 | 73 | 66 | 205 |
| 41 | 40 | 57 | 138 | | 0 | 32 | 8 | 40 |
| 41 | 65 | 66 | 172 | | 8 | 32 | 33 | 73 |
| 41 | 56 | 57 | 154 | | 8 | 24 | 24 | 56 |
| 8 | 32 | 33 | 73 | | 0 | 24 | 24 | 48 |
| 0 | 24 | 24 | 48 | | 0 | 24 | 24 | 48 |
| 0 | 16 | 33 | 49 | | 8 | 32 | 33 | 73 |
| 0 | 24 | 24 | 48 | | 8 | 32 | 33 | 73 |
| 0 | 16 | 33 | 49 | | 8 | 32 | 33 | 73 |
| 8 | 32 | 33 | 73 | | 0 | 24 | 24 | 48 |
| 8 | 24 | 24 | 56 | | 8 | 24 | 24 | 56 |
| 8 | 24 | 24 | 56 | | 8 | 32 | 33 | 73 |
| 0 | 16 | 8 | 24 | | 8 | 24 | 24 | 56 |
| 8 | 32 | 8 | 48 | | 0 | 32 | 8 | 40 |
| 0 | 16 | 8 | 24 | | 0 | 32 | | 40 |
| 8 | 40 | 8 | 56 | | 0 | 32 | 8 | 40 |
| 8 | 24 | 24 | 56 | | 0 | 24 | 24 | 48 |
| 24 | 24 | 24 | 72 | | 0 | 16 | 8 | 24 |
| 8 | 24 | 24 | 56 | | 0 | 8 | 0 | 8 |
| 0 | 8 | 0 | 8 | | 0 | 16 | 33 | 49 |
| 8 | 24 | 24 | 56 | | 90 | 113 | 99 | 302 |
| 8 | 24 | 24 | 56 | | 165 | 174 | 189 | 528 |
| 8 | 16 | 33 | 57 | | 198 | 190 | 214 | 602 |
| 8 | 16 | 33 | 57 | | 107 | 113 | 132 | 352 |
| 0 | 8 | 0 | 8 | | 24 | 24 | 24 | 72 |
| 57 | 56 | 49 | 162 | | 24 | 32 | 49 | 105 |
| 123 | 134 | 140 | 397 | | 24 | 32 | 49 | 105 |
| 222 | 231 | 231 | 684 | | 24 | 40 | 33 | 97 |
| 165 | 166 | 140 | 471 | | 8 | 32 | 33 | 73 |
| 57 | 73 | 49 | 179 | | 8 | 24 | 24 | 56 |
| 24 | 48 | 49 | 121 | | 8 | 32 | 33 | 73 |
| 8 | 32 | 33 | 73 | | 8 | 16 | 33 | 57 |
| 8 | 48 | 49 | 105 | | 0 | 8 | 24 | 32 |
| 0 | 24 | 24 | 48 | | 0 | 16 | 33 | 49 |
| 8 | 32 | 33 | 73 | | 0 | 32 | 8 | 40 |
| 0 | 32 | 8 | 40 | | 0 | 32 | 8 | 40 |
| 0 | 16 | 33 | 49 | | 0 | 24 | 24 | 48 |
| 0 | 24 | 24 | 48 | | 16 | 56 | 8 | 80 |
| 0 | 8 | 0 | 8 | | 0 | 24 | 24 | 48 |
| 0 | 8 | 24 | 32 | | 0 | 32 | 8 | 40 |
| 0 | 8 | 0 | 8 | | 0 | 24 | 24 | 48 |
| 0 | 24 | 24 | 48 | | 0 | 24 | 24 | 48 |
| 0 | 24 | 24 | 48 | | 0 | 32 | 8 | 40 |
| 0 | 16 | 33 | 49 | | 0 | 16 | 8 | 24 |
| 8 | 32 | 33 | 73 | | 0 | 24 | 24 | 48 |
| 8 | 16 | 33 | 57 | | 0 | 24 | 24 | 48 |
| 8 | 16 | 33 | 57 | | 8 | 32 | 8 | 48 |
| 0 | 8 | 0 | 8 | | 0 | 32 | 8 | 40 |
| 0 | 8 | 0 | 8 | | 0 | 16 | 8 | 24 |
| 24 | 24 | 24 | 72 | | 0 | 16 | 8 | 24 |
| 0 | 8 | 0 | 8 | | 8 | 24 | 24 | 56 |
| 24 | 24 | 24 | 72 | | 8 | 24 | 24 | 56 |
| 0 | 8 | 0 | 8 | | 0 | 8 | 0 | 8 |
| 0 | 16 | 8 | 24 | | 0 | 8 | 0 | 8 |
| 8 | 24 | 24 | 56 | | 0 | 32 | 8 | 40 |
| 0 | 8 | 24 | 32 | | 0 | 16 | 8 | 24 |
| 0 | 16 | 8 | 24 | | 0 | 16 | 8 | 24 |
| 0 | 16 | 8 | 24 | | 0 | 8 | 0 | 8 |
| 0 | 16 | 8 | 24 | | 0 | 16 | 8 | 24 |
| 0 | 32 | 8 | 40 | | 0 | 16 | 8 | 24 |
| 0 | 16 | 8 | 24 | | 0 | 16 | 8 | 24 |
| 0 | 16 | 8 | 24 | | 0 | 16 | 8 | 24 |
| 0 | 16 | 8 | 24 | | 0 | 24 | 24 | 48 |
| 0 | 16 | 8 | 24 | | 0 | 24 | 24 | 48 |
| 8 | 16 | 33 | 57 | | 8 | 32 | 33 | 73 |
| 0 | 16 | 33 | 49 | | 0 | 8 | 24 | 32 |
| 0 | 8 | 0 | 8 | | 24 | 32 | 49 | 105 |
| 0 | 8 | 0 | 8 | | 107 | 113 | 132 | 352 |
| 90 | 113 | 99 | 302 | | 189 | 199 | 189 | 577 |
| 247 | 247 | 247 | 741 | | 222 | 215 | 247 | 684 |
| 247 | 247 | 247 | 741 | | 189 | 182 | 165 | 536 |
| 189 | 199 | 189 | 577 | | 90 | 97 | 107 | 294 |
| 41 | 65 | 41 | 147 | | 24 | 24 | 24 | 72 |
| 8 | 40 | 8 | 56 | | 0 | 8 | 0 | 8 |
| 0 | 32 | 8 | 40 | | 0 | 32 | 8 | 40 |
| 0 | 32 | 8 | 40 | | 0 | 16 | 8 | 24 |
| 0 | 32 | 8 | 40 | | 0 | 32 | 8 | 40 |
| 0 | 32 | 8 | 40 | | 0 | 16 | 8 | 24 |
| 0 | 16 | 8 | 24 | | 0 | 32 | 8 | 40 |
| 0 | 8 | 0 | 8 | | 0 | 16 | 8 | 24 |
| 0 | 8 | 0 | 8 | | 0 | 8 | 0 | 8 |
| 8 | 24 | 24 | 56 | | 0 | 16 | 8 | 24 |
| 0 | 8 | 0 | 8 | | 0 | 8 | 0 | 8 |
| 0 | 8 | 0 | 8 | | 57 | 73 | 66 | 196 |
| 0 | 8 | 0 | 8 | | 140 | 142 | 140 | 422 |
| 90 | 113 | 99 | 302 | | 206 | 239 | 247 | 692 |
| 189 | 182 | 165 | 536 | | 222 | 215 | 206 | 643 |
| 222 | 231 | 231 | 684 | | 123 | 134 | 140 | 397 |
| 206 | 207 | 181 | 594 | | 57 | 40 | 66 | 163 |
| 140 | 134 | 107 | 381 | | 0 | 8 | 0 | 8 |
| 41 | 32 | 41 | 114 | | 0 | 8 | 0 | 8 |
| 0 | 8 | 0 | 8 | | 0 | 8 | 0 | 8 |
| 8 | 24 | 24 | 56 | | 0 | 8 | 0 | 8 |
| 0 | 8 | 0 | 8 | | 8 | 24 | 24 | 56 |
| 0 | 8 | 0 | 8 | | 8 | 16 | 33 | 57 |
| 0 | 8 | 0 | 8 | | 0 | 8 | 24 | 32 |
| 0 | 16 | 8 | 24 | | 0 | 8 | 0 | 8 |
| 0 | 16 | 8 | 24 | | 8 | 24 | 24 | 56 |
| 0 | 16 | 8 | 24 | | 0 | 8 | 0 | 8 |
| 0 | 8 | 24 | 32 | | 0 | 8 | 0 | 8 |
| 0 | 8 | 0 | 8 | | 66 | 73 | 66 | 205 |
| 8 | 24 | 24 | 56 | | 140 | 142 | 140 | 422 |
| 24 | 40 | 33 | 97 | | 222 | 231 | 231 | 684 |
| 140 | 142 | 140 | 422 | | 206 | 207 | 214 | 627 |
| 247 | 247 | 247 | 741 | | 189 | 182 | 165 | 536 |
| 222 | 231 | 231 | 684 | | 57 | 56 | 49 | 162 |
| 165 | 150 | 181 | 496 | | 0 | 8 | 0 | 8 |
| 41 | 32 | 41 | 114 | | 0 | 16 | 8 | 24 |
| 0 | 8 | 0 | 8 | | 0 | 16 | 8 | 24 |
| 8 | 24 | 24 | 56 | | 0 | 16 | 8 | 24 |
| 8 | 24 | 24 | 56 | | 0 | 16 | 8 | 24 |
| 8 | 24 | 24 | 56 | | 0 | 16 | 8 | 24 |
| 0 | 16 | 8 | 24 | | 0 | 16 | 8 | 24 |
| 0 | 16 | 8 | 24 | | 0 | 24 | 24 | 48 |
| 0 | 16 | 8 | 24 | | 8 | 16 | 33 | 57 |
| 0 | 8 | 0 | 8 | | 8 | 24 | 24 | 56 |
| 0 | 16 | 8 | 24 | | 8 | 24 | 24 | 56 |
| 0 | 24 | 24 | 48 | | 8 | 24 | 24 | 56 |
| 0 | 8 | 24 | 32 | | 24 | 24 | 24 | 72 |
| 0 | 8 | 24 | 32 | | 24 | 24 | 24 | 72 |
| 0 | 8 | 24 | 32 | | 0 | 16 | 8 | 24 |
| 0 | 8 | 0 | 8 | | 0 | 16 | 8 | 24 |
| 0 | 8 | 0 | 8 | | 0 | 16 | 8 | 24 |
| 0 | 8 | 0 | 8 | | 8 | 32 | 8 | 48 |
| 0 | 8 | 0 | 8 | | 8 | 24 | 24 | 56 |
| 0 | 8 | 0 | 8 | | 0 | 8 | 0 | 8 |
| 0 | 8 | 0 | 8 | | 0 | 16 | 8 | 24 |
| 8 | 16 | 33 | 57 | | 0 | 16 | 8 | 24 |
| 8 | 16 | 33 | 57 | | 0 | 24 | 24 | 48 |
| 0 | 8 | 0 | 8 | | 0 | 16 | 8 | 24 |
| 0 | 8 | 0 | 8 | | 0 | 8 | 24 | 32 |
| 0 | 16 | 8 | 24 | | 0 | 24 | 24 | 48 |
| 0 | 16 | 8 | 24 | | 0 | 16 | 8 | 24 |
| 0 | 8 | 0 | 8 | | 0 | 8 | 0 | 8 |
| 0 | 8 | 0 | 8 | | 0 | 16 | 8 | 24 |
| 0 | 8 | 0 | 8 | | 8 | 24 | 24 | 56 |
| 0 | 8 | 0 | 8 | | 0 | 8 | 0 | 8 |
| 0 | 8 | 0 | 8 | | 0 | 16 | 8 | 24 |
| 0 | 8 | 0 | 8 | | 0 | 8 | 0 | 8 |
| 0 | 8 | 0 | 8 | | 0 | 8 | 0 | 8 |
| 0 | 8 | 0 | 8 | | 0 | 8 | 0 | 8 |
| 0 | 16 | 8 | 24 | | 0 | 16 | 8 | 24 |
| 0 | 16 | 8 | 24 | | 0 | 16 | 8 | 24 |
| 0 | 16 | 8 | 24 | | 0 | 16 | 8 | 24 |
| 0 | 32 | 8 | 40 | | 0 | 8 | 24 | 32 |
| 0 | 16 | 8 | 24 | | 0 | 8 | 0 | 8 |
| 0 | 24 | 24 | 48 | | 0 | 8 | 0 | 8 |
| 0 | 8 | 24 | 32 | | 8 | 16 | 33 | 57 |
| 0 | 16 | 33 | 49 | | 8 | 16 | 33 | 57 |
| 0 | 8 | 0 | 8 | | 0 | 8 | 0 | 8 |
| 0 | 16 | 33 | 49 | | 8 | 32 | 33 | 73 |
| 0 | 16 | 33 | 49 | | 57 | 56 | 66 | 179 |
| 0 | 8 | 24 | 32 | | 140 | 142 | 140 | 422 |
| 41 | 40 | 57 | 138 | | 189 | 199 | 189 | 577 |
| 90 | 113 | 99 | 302 | | 247 | 247 | 247 | 741 |
| 206 | 207 | 294 | 627 | | 206 | 207 | 214 | 627 |
| 247 | 247 | 247 | 741 | | 148 | 142 | 140 | 430 |
| 247 | 247 | 247 | 741 | | 24 | 16 | 49 | 89 |
| 148 | 142 | 140 | 430 | | 0 | 8 | 0 | 8 |
| 0 | 8 | 0 | 8 | | 0 | 8 | 0 | 8 |
| 0 | 8 | 0 | 8 | | 0 | 8 | 0 | 8 |
| 0 | 8 | 0 | 8 | | 0 | 16 | 8 | 24 |
| 0 | 32 | 8 | 40 | | 0 | 16 | 8 | 24 |
| 0 | 16 | 8 | 24 | | 0 | 8 | 0 | 8 |
| 0 | 8 | 0 | 8 | | 0 | 8 | 0 | 8 |
| 0 | 8 | 0 | 8 | | 0 | 8 | 0 | 8 |
| 0 | 8 | 24 | 32 | | 0 | 8 | 24 | 32 |
| 8 | 24 | 24 | 56 | | 24 | 40 | 66 | 130 |
| 8 | 16 | 33 | 57 | | 66 | 105 | 90 | 261 |
| 0 | 8 | 0 | 8 | | 123 | 150 | 165 | 438 |
| 57 | 73 | 49 | 179 | | 206 | 207 | 214 | 627 |
| 123 | 150 | 148 | 421 | | 231 | 247 | 247 | 725 |
| 222 | 215 | 206 | 643 | | 222 | 231 | 231 | 684 |
| 231 | 247 | 247 | 725 | | 189 | 182 | 165 | 536 |
| 247 | 247 | 247 | 741 | | 115 | 97 | 132 | 344 |
| 148 | 158 | 132 | 438 | | 107 | 97 | 90 | 294 |
| 41 | 89 | 41 | 171 | | 66 | 73 | 66 | 205 |
| | | | | | | | | |
| | | | | | | | | |
| | | | | | | | | |
| | | | | | | | | |
| | | | | | | | | |

## Claims

1. A method for detecting a wafer position in a carrier having a plurality of slots from an acquired image of the wafer by detecting a first feature (509) of the wafer at a first location in a first column (490) of the image (400), the method **characterized by**:
detecting a second feature (609) of the wafer at a second location in a second column (490) of the image (400); and
comparing the first location in the first column (490) to the second location in the second column (495) to determine the orientation of the wafer (458).

2. The method of claim 1 wherein the image (400) is acquired using a camera (101).

3. The method of claim 2 wherein the camera (101) is a video camera.

4. The method of claim 2 wherein the camera (101) is a digital camera.

5. The method of claim 2 wherein the image (400) is a digitized image.

6. The method of claim 1 wherein the first feature (509) is represented in the first column (490) as a peak intensity.

7. The method of claim 1 wherein the first feature (509) is represented as peak intensity in the first column (490) and the second feature (609) is represented as peak intensity in the second column (495).

8. A method according to any of claims 1 to 7, further comprising:
determining where in the first column (490) the first feature (509) is detected;
determining where in the second column (495) the second feature (609) is detected; and
comparing where the first feature (509) is detected in the first column, (490) to where the second feature (609) is detected in the second column (495) to determine if the semiconductor wafer (458) is cross-slotted.

## Patentansprüche

1. Verfahren zum Erkennen einer Waferposition in einem Träger mit einer Mehrzahl von Steckplätzen von einem erfassten Bild des Wafers durch Erkennen eines ersten Merkmals (509) des Wafers an einer ersten Stelle in einer ersten Spalte (490) des Bildes (400), wobei das Verfahren **gekennzeichnet ist durch**:
Erkennen eines zweiten Merkmals (609) des Wafers an einer zweiten Stelle in einer zweiten Spalte (490) des Bildes (400); und
Vergleichen der ersten Stelle in der ersten Spalte (490) mit der zweiten Stelle in der zweiten Spalte (495), um die Ausrichtung des Wafers (458) zu ermitteln.

2. Verfahren nach Anspruch 1, wobei das Bild (400) mit einer Kamera (101) erfasst wird.

3. Verfahren nach Anspruch 2, wobei die Kamera (101) eine Videokamera ist.

4. Verfahren nach Anspruch 2, wobei die Kamera (101) eine Digitalkamera ist.

5. Verfahren nach Anspruch 2, wobei das Bild (400) ein digitalisiertes Bild ist.

6. Verfahren nach Anspruch 1, wobei das erste Merkmal (509) in der ersten Spalte (490) als eine Spitzenintensität dargestellt wird.

7. Verfahren nach Anspruch 1, wobei das erste Merkmal (509) als Spitzenintensität in der ersten Spalte (490) und das zweite Merkmal (609) als Spitzenintensität in der zweiten Spalte (495) dargestellt wird.

8. Verfahren nach einem der Ansprüche 1 bis 7, das ferner Folgendes beinhaltet:
Ermitteln, wo in der ersten Spalte (490) das erste Merkmal (509) erkannt wird;
Ermitteln, wo in der zweiten Spalte (495) das zweite Merkmal (609) erkannt wird; und
Vergleichen, wo das erste Merkmal (509) in der ersten Spalte (490) erkannt wird, damit, wo das zweite Merkmal (609) in der zweiten Spalte (495) erkannt wird, um zu ermitteln, ob der Halbleiterwafer (458) zwei Steckplätze belegt.

## Revendications

1. Un procédé de détection d'une position de plaquette dans un support possédant une pluralité de fentes à partir d'une image acquise de la plaquette en détectant une première caractéristique (509) de la plaquette dans un premier emplacement d'une première colonne (490) de l'image (400), le procédé étant **caractérisé par** :
la détection d'une deuxième caractéristique (609) de la plaquette dans un deuxième emplacement d'une deuxième colonne (490) de l'image (400) et
la comparaison du premier emplacement de la premier colonne (490) avec le deuxième emplacement de la deuxième colonne (495) afin de déterminer l'orientation de la plaquette (458).

2. Le procédé selon la Revendication 1 où l'image (400) est acquise au moyen d'une caméra (101).

3. Le procédé selon la Revendication 2 où la caméra (101) est une caméra vidéo.

4. Le procédé selon la Revendication 2 où la caméra (101) est une caméra numérique.

5. Le procédé selon la Revendication 2 où l'image (400) est une image numérisée.

6. Le procédé selon la Revendication 1 où la première caractéristique (509) est représentée dans la première colonne (490) sous la forme d'une intensité de crête.

7. Le procédé selon la Revendication 1 où la première caractéristique (509) est représentée sous la forme d'une intensité de crête dans la première colonne (490) et la deuxième caractéristique (609) est représentée sous la forme d'une intensité de crête dans la deuxième colonne (495).

8. Un procédé selon l'une quelconque des Revendications 1 à 7 comprenant en outre :
la détermination du point dans la première colonne (490) où la première caractéristique (509) est détectée ;
la détermination du point dans la deuxième colonne (495) où la deuxième caractéristique (609) est détectée ; et
la comparaison du point où la première caractéristique (509) est détectée dans la première colonne (490) avec le point où la deuxième caractéristique (609) est détectée dans la deuxième colonne (495) afin de déterminer si la plaquette à semi-conducteurs (458) couvre deux fentes.
